# EUROPEAN PATENT APPLICATION

(11) **EP 4 629 282 A1**
(43) Date of publication of application: **08.10.2025**
(21) Application number: 23897720.1
(22) Date of filing: 27.11.2023
(51) Int. Cl.: H01L 21/306, H01L 21/336, H01L 29/788, H01L 29/792, H10B 43/27

(54) **METHOD FOR FORMING SEMICONDUCTOR ELEMENT**

(30) Priority: 30.11.2022 JP 2022192001
(71) Applicant: SCREEN Holdings Co., Ltd., Kyoto-shi, Kyoto 602-8585 (JP)
(72) Inventor: ISHIZU Takaaki, Kyoto-shi, Kyoto 602-8585 (JP)
(74) Representative: Kilian Kilian & Partner mbB
(86) International application number: PCT/JP2023/042334
(87) International publication number: WO 2024/117072

(57) **Abstract**

A semiconductor device forming method is provided, which includes: a first coating film forming step (S10) of forming a first coating film (Ps1) that covers a recess (R) provided in a multilayer structure (L) supported on a base (S); a second coating film forming step (S20) of forming a second coating film (Ps2) that selectively covers a surface-side portion of the recess (R) formed with the first coating film (Ps1) over the first coating film (Ps1); and a first chemical liquid etching step (S31) of etching a deeper recess portion (Rf) of the recess (R) not covered with the second coating film (Ps2) by using a first chemical liquid (C1) so as to expand the width of the deeper recess portion (Rf).

## Description

### TECHNICAL FIELD

The present invention relates to a semiconductor device forming method.

### BACKGROUND ART

A semiconductor device forming method described in PTL 1 includes a coating layer forming step and an etching step. In the coating layer forming step, a coating layer is formed in a recess provided in a multilayer structure supported on a base so as to selectively cover a portion of the recess present on the surface side of the multilayer structure. In the etching step, a deeper portion of the recess that is deeper than the coating layer is etched with a chemical liquid for expansion of the diameter thereof.

### CITATION LIST

### PATENT LITERATURE

PTL 1: JP2021-34691A

### SUMMARY OF INVENTION

### PROBLEMS TO BE SOLVED BY INVENTION

In the semiconductor device forming method described in PTL 1, the multilayer structure is formed by alternately stacking layers of different materials. Therefore, the coating layer needs to be formed on the layers of the different materials simultaneously.

The inventor of the present invention conducted intensive studies focusing on adsorption sites on the layers of the different materials for adsorption of the molecules of a coating layer material. As a result, the inventor found that layers of one of the different materials often each have a smaller number of adsorption sites for the absorption of the molecules of the coating layer material than layers of the other material. Consequently, the inventor inferred that the layers having a smaller number of adsorption sites are liable to have a greater number of non-adsorption areas in which the molecules of the coating layer material are not adsorbed. Further, the inventor inferred that, if the number of the non-adsorption areas is increased in the coating layer, layers in a portion of the recess that does not need the expansion of the diameter thereof are liable to be etched with the chemical liquid. The term "diameter" is herein defined as an example of the term "width."

The present invention has been achieved in view of the foregoing, and it is an object of the present invention to provide a semiconductor device forming method that can suppress the etching with a chemical liquid on a recess portion of a substrate that does not need the expansion of the width thereof.

### SOLUTION TO PROBLEMS

According to one aspect of the present invention, a semiconductor device forming method includes the steps of: forming a first coating film that covers a recess provided in a multilayer structure supported on a base; forming a second coating film that selectively covers a surface-side portion of the recess formed with the first coating film over the first coating film; and etching a deeper recess portion of the recess not covered with the second coating film by using a first chemical liquid so as to expand the width of the deeper recess portion.

In one example embodiment, the method further includes the steps of: removing the second coating film after the first chemical liquid etching step; and removing the first coating film after the second coating film removing step.

In another example embodiment, the first coating film is removed by using a second chemical liquid and the deeper recess portion is etched with the second chemical liquid in the first coating film removing step.

In further another example embodiment, the first coating film is formed by using an ALD method, ozone water, hydrogen peroxide water or a mixture liquid of sulfuric acid and hydrogen peroxide water in the first coating film forming step.

In still another example embodiment, the number of adsorption sites per unit area of the surface of the first coating film for adsorption of a material of the second coating film is greater than an adsorption site number per unit area of the surface of a specific one of different layers of the multilayer structure. The specific layer has the smallest adsorption site number per unit area among the different layers of the multilayer structure.

In further another example embodiment, the adsorption sites each contain a hydroxyl group.

In still another example embodiment, the second coating film forming step includes the steps of: forming a partial filling layer that partly fills the deeper recess portion of the recess over the first coating film; supplying a water repellent after the formation of the partial filling layer; and removing the partial filling layer and the water repellent after forming the second coating film on the first coating film in the surface-side portion of the recess by the supply of the water repellent.

In further another example embodiment, the partial filling layer forming step includes the steps of: forming a filling layer that fills the recess over the first coating film; and partly removing the filling layer after the formation of the filling layer.

### EFFECT OF INVENTION

According to the present invention, the etching with the chemical liquid can be suppressed in a portion of a recess of a substrate that does not need the expansion of the width thereof.

### BRIEF DESCRIPTION OF DRAWINGS

[FIG. 1] is a schematic diagram of a substrate treatment apparatus according to an example embodiment of the present invention.
[FIG. 2] is a schematic diagram of the substrate treatment apparatus according to the example embodiment.
[FIG. 3] is a block diagram of the substrate treatment apparatus according to the example embodiment.
[FIGS. 4] (a) is a schematic side view of a semiconductor device to be produced by using the substrate treatment apparatus according to the example embodiment, and (b) is a schematic top plan view of the semiconductor device. (c) is a partially enlarged diagram of (b).
[FIGS. 5] (a) to (e) are schematic diagrams to be used to describe a semiconductor device forming method according to the example embodiment.
[FIGS. 6] (a) to (g) are schematic diagrams to be used to describe a semiconductor device forming method according to a comparative example.
[FIGS. 7] (a) to (c) are schematic diagrams to be used to describe the surface states of an insulating layer of a multilayer structure of a substrate according to the comparative example.
[FIGS. 8] (a) to (c) are schematic diagrams to be used to describe the surface states of a sacrificial layer of the multilayer structure of the substrate according to the comparative example.
[FIGS. 9] (a) and (b) are schematic diagrams to be used to describe the semiconductor device forming method according to the example embodiment.
[FIGS. 10] (a) and (b) are schematic diagrams to be used to describe the semiconductor device forming method according to the example embodiment.
[FIGS. 11] (a) and (b) are schematic diagrams to be used to describe the semiconductor device forming method according to the example embodiment.
[FIGS. 12] (a) and (b) are schematic diagrams to be used to describe the semiconductor device forming method according to the example embodiment.
[FIGS. 13] (a) and (b) are schematic diagrams to be used to describe the semiconductor device forming method according to the example embodiment.
[FIGS. 14] (a) to (c) are schematic diagrams to be used to describe the surface states of a first coating film according to the example embodiment.
[FIG. 15] is a flow diagram of the semiconductor device forming method according to the example embodiment.
[FIG. 16] is a flow diagram of the semiconductor device forming method according to the example embodiment.
[FIG. 17] is a schematic diagram of another substrate treatment apparatus according to the example embodiment.
[FIG. 18] is a schematic diagram of another semiconductor device produced by the semiconductor device forming method according to the example embodiment.

### DESCRIPTION OF EXAMPLE EMBODIMENTS

With reference to the drawings, a semiconductor device forming method according to an example embodiment of the present invention will hereinafter be described. In the drawings, the same or corresponding components will be denoted by the same reference characters, and duplicate description will be omitted. An X-axis, a Y-axis and a Z-axis orthogonal to each other are herein sometimes used for easy understanding of the present invention. Typically, the X-axis and the Y-axis are parallel to a horizontal direction, and the Z-axis is parallel to a vertical direction. Further, an x-axis, a y-axis and a z-axis orthogonal to each other are herein sometimes used for easy understanding of the present invention. Typically, the x-axis and the y-axis extend parallel to a major surface of a substrate or a base, and the z-axis extends perpendicularly to the major surface of the substrate or the base.

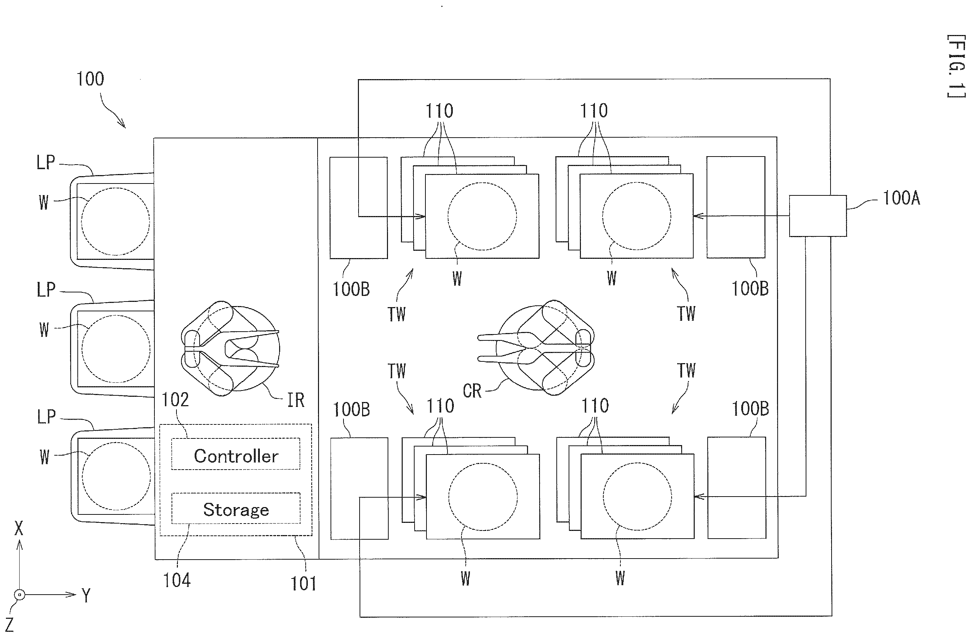

Referring to FIG. 1, a substrate treatment apparatus 100 according to the example embodiment of the present invention will be first described. FIG. 1 is a schematic plan view of the substrate treatment apparatus 100 according to this example embodiment.

The substrate treatment apparatus 100 treats a substrate W. The substrate treatment apparatus 100 treats the substrate W so as to perform at least one of an etching process, a surface treatment, a property imparting process, a film forming process, an at least partial film removing process and a cleaning process on the substrate W.

The substrate W is used as a semiconductor substrate. The substrate W includes a semiconductor wafer. For example, the substrate W has a substantially disk shape. Here, the substrate treatment apparatus 100 treats substrates W one by one.

As shown in FIG. 1, the substrate treatment apparatus 100 includes a plurality of chambers 110, a fluid cabinet 100A, fluid boxes 100B, a plurality of load ports LP, an indexer robot IR, a center robot CR and a control device 101. The control device 101 controls the load ports LP, the indexer robot IR and the center robot CR.

The load ports LP each accommodate a stack of substrates W. The indexer robot IR transports a substrate W between the load ports LP and the center robot CR. The center robot CR transports the substrate W between the indexer robot IR and any of the chambers 110. In each of the chambers 110, liquid is spouted toward a substrate W to treat the substrate W. Examples of the liquid include a treatment liquid, a removing liquid, a water repellent and a chemical liquid. The fluid cabinet 100A stores the liquid. The fluid cabinet 100A may store gas.

Specifically, the chambers 110 constitute a plurality of towers TW (four towers TW in FIG. 1), which are disposed around the center robot CR as seen in plan. The towers TW each include a plurality of chambers 110 (three chambers 110 in FIG. 1) stacked one on another. The fluid boxes 100B respectively correspond to the towers TW. The liquid in the fluid cabinet 100A is supplied to all the chambers 110 in each of the towers TW through a corresponding one of the fluid boxes 100B. Further, the gas in the fluid cabinet 100A is supplied to all the chambers 110 in each of the towers TW through a corresponding one of the fluid boxes 100B.

The control device 101 controls operations to be performed by the substrate treatment apparatus 100. The control device 101 includes a controller 102 and a storage 104.

The controller 102 includes a processor. The controller 102 includes, for example, a central processing unit (CPU). Alternatively, the controller 102 may include a general purpose computer.

The storage 104 stores data and a computer program. The data includes recipe data. The recipe data includes information about a plurality of recipes. The recipes each define a process and a procedure for the treatment of the substrate W.

The storage 104 includes a main storage and an auxiliary storage. The main storage is, for example, a semiconductor memory. The auxiliary storage is, for example, a semiconductor memory and/or a hard disk drive. The storage 104 may include a removable medium. The storage 104 corresponds to an exemplary non-temporary computer-readable storage medium. The controller 102 executes the computer program stored in the storage 104 to perform a substrate treatment operation.

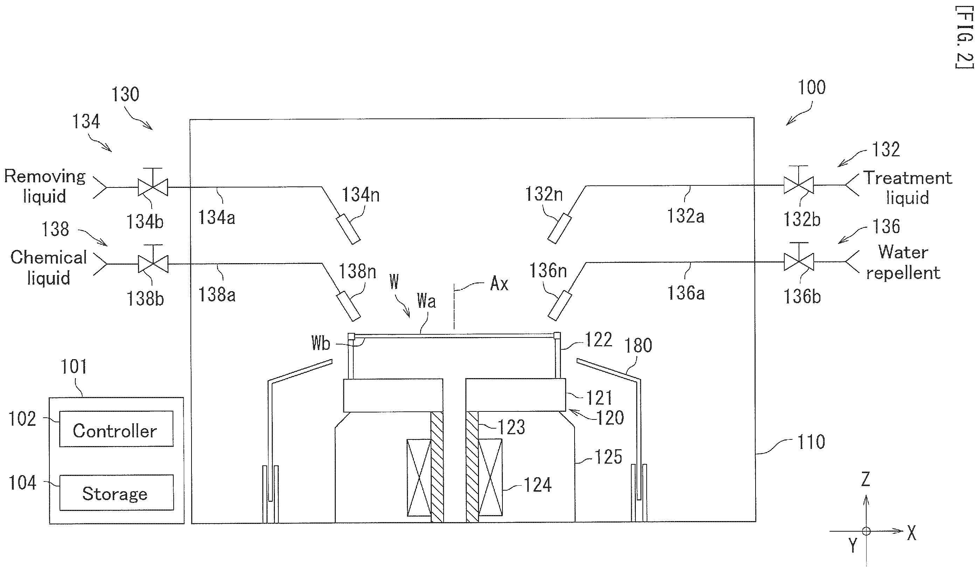

Referring next to FIG. **2****,** the substrate treatment apparatus 100 according to this example embodiment will be described. FIG. 2 is a schematic diagram of the substrate treatment apparatus 100.

The substrate treatment apparatus 100 includes the chambers 110, a substrate holding unit 120 and a liquid supplying unit 130. The chambers 110 each accommodate a substrate W. The substrate holding unit 120 holds the substrate **W.**

The chamber 110 has a generally box shape having a inside space. The chamber 110 accommodates the substrate **W.** The substrate treatment apparatus 100 is of a single substrate treatment type, which is adapted to treat substrates W one by one, and the chamber 110 accommodates a single substrate W at a time. The substrate W is held in the chamber 110, and treated in the chamber 110. The substrate holding unit 120 and the liquid supplying unit 130 are each at least partly accommodated in the chamber 110.

The substrate holding unit 120 holds the substrate **W.** The substrate holding unit 120 horizontally holds the substrate W with the upper surface (the front surface) Wa of the substrate W facing up and with the back surface (the lower surface) Wb of the substrate W facing down. Further, the substrate holding unit 120 rotates the substrate W while holding the substrate W. As will be described later in detail, the upper surface Wa of the substrate W is formed with a multilayer structure having recesses. The recesses are each defined as an indented portion formed in the substrate **W.** Examples of the recess include a hole and a trench formed in the substrate **W.** An example of the hole includes a memory hole.

The substrate holding unit 120 may be, for example, of an edge holding type, which is adapted to hold the edge of the substrate **W.** Alternatively, the substrate holding unit 120 may have a certain mechanism adapted to hold the back surface Wb of the substrate W. For example, the substrate holding unit 120 may be of a vacuum type. In this case, the substrate holding unit 120 sucks the center portion of the back surface Wb (non-device-formation surface) of the substrate W on its upper surface to horizontally hold the substrate W. Alternatively, the substrate holding unit 120 may be a combination of the vacuum type and the edge holding type including a plurality of chuck pins which are kept in contact with the peripheral edge surface of the substrate **W.**

The substrate holding unit 120 includes, for example, a spin base 121, a chuck member 122, a shaft 123, an electric motor 124 and a housing 125. The chuck member 122 is provided on the spin base 121. The chuck member 122 chucks the substrate W. The chuck member 122 typically includes a plurality of chuck members 122 provided on the spin base 121.

The shaft 123 is a hollow shaft. The shaft 123 extends vertically along a rotation axis Ax. The spin base 121 is connected to the upper end of the shaft 123. The substrate W is held above the spin base 121.

The spin base 121 has a disk shape, and supports the substrate W horizontally. The shaft 123 extends downward from the center portion of the spin base 121. The electric motor 124 applies a turning force to the shaft 123. The electric motor 124 rotates the shaft 123 in a rotation direction to thereby rotate the substrate W and the spin base 121 about the rotation axis Ax. The housing 125 surrounds the shaft 123 and the electric motor 124.

The liquid supplying unit 130 supplies the liquid to the substrate W. Typically, the liquid supplying unit 130 supplies the liquid to the upper surface Wa of the substrate W.

The liquid supplying unit 130 includes a treatment liquid supplying unit 132, a removing liquid supplying unit 134, a water repellent supplying unit 136 and a chemical liquid supplying unit 138. The treatment liquid supplying unit 132, the removing liquid supplying unit 134, the water repellent supplying unit 136 and the chemical liquid supplying unit 138 are each at least partly accommodated in the chamber 110.

The treatment liquid supplying unit 132 supplies the treatment liquid to the upper surface Wa of the substrate **W.** The treatment liquid contains a solute and a volatile solvent. After the treatment liquid is supplied to the upper surface Wa of the substrate **W,** the solvent evaporates, whereby a filling layer is formed from the solute. The filling layer is a solid film composed of a solute component. The filling layer can capture particles remaining in the recesses of the substrate W. When the filling layer is formed, particles adhering to the upper surface Wa of the substrate W are removed from the substrate W and retained in the filling layer.

The term "solidification" means that the solute is solidified by an intermolecular force, an interatomic force or the like as the solvent evaporates. The term "curing" means that the solute is cured due to a chemical change such as polymerization, crosslinking or the like. Therefore, an expression "solidification or curing" means that the solute is hardened due to any of various factors. It is noted that the treatment liquid is merely required to be solidified or cured to an extent such as to retain the particles but the solvent does not need to completely evaporate. Further, the solute component that forms the filling layer may be the solute itself contained in the treatment liquid, or may be a component derived from the solute **(e.g.,** a component obtained as a result of the chemical change).

Usable as the solute is any of various resins that are soluble in a given solvent and are capable of forming the filling layer with the particles removed from the upper surface of the substrate W and retained therein when being solidified or cured. For example, a resin that is less soluble or insoluble in water before being heated to not lower than a certain alteration temperature and is altered to be water-soluble when being heated to not lower than the alteration temperature (hereinafter sometimes referred to as "heat-sensitive water-soluble resin") may be used as the solute.

Usable as the heat-sensitive water-soluble resin is, for example, a resin or the like that is decomposed to exhibit water solubility with its polar functional groups exposed when being heated to not lower than a certain alteration temperature (e.g., not lower than 200°C). The heat-sensitive water-soluble resin is altered to be water-soluble when being heated to not lower than the alteration temperature.

Alternatively, the filling layer may be formed so as to be less soluble or insoluble in an aqueous liquid by keeping the temperature of the heat-sensitive water-soluble resin below the alteration temperature. For the formation of the filling layer, the temperature of the treatment liquid is kept at lower than the alteration temperature of the heat-sensitive water-soluble resin, whereby the heat-sensitive water-soluble resin is not altered to be water-soluble. Thus, the filling layer that is less soluble or insoluble in the aqueous liquid can be formed on the upper surface of the substrate W. In this case, the filling layer can be removed from the substrate W in a lump without releasing the particles therefrom. Therefore, the particles can be removed at a higher removal rate.

Examples of the solute to be contained in the treatment liquid other than the heat-sensitive water-soluble resin include acrylic resins, phenolic resins, epoxy resins, melamine resins, urea resins, unsaturated polyester resins, alkyd resins, polyurethanes, polyimides, polyethylenes, polypropylenes, polyvinyl chlorides, polystyrenes, polyvinyl acetates, polytetrafluoroethylenes, acrylonitrile-butadiene-styrene resins, acrylonitrile-styrene resins, polyamides, polyacetals, polycarbonates, polyvinyl alcohols, modified polyphenylene ethers, polybutylene terephthalates, polyethylene terephthalates, polyphenylene sulfides, polysulfones, polyether ether ketones and polyamideimides.

The solvent preferably has a higher volatility than water. PGEE (polypropylene glycol monoethyl ether) is preferably used as the solvent.

Further, the treatment liquid may contain a sublimable substance. Usable as the sublimable substance is any of various substances that each have a higher vapor pressure at 5°C to 35°C and change from a solid phase to a gas phase not through a liquid phase. Examples of the sublimable substance include hexamethylene tetramine, 1,3,5-trioxane, ammonium 1-pyrrolidinecarbodithioate, metaldehyde, paraffins each having 20 to 48 carbon atoms, t-butanol, paradichlorobenzene, naphthalene, L-menthol and a fluorinated hydrocarbon compound. Particularly, the fluorinated hydrocarbon compound can be used as the sublimable substance.

Usable as the fluorinated hydrocarbon compound is, for example, one or two or more of the following compounds (A) to (E):
(A) C3 to C6 fluoroalkanes and their derivatives;
(B) C3 to C6 fluorocycloalkanes and their derivatives;
(C) C10 fluorobicycloalkanes and their derivatives;
(D) Fluorotetracyanoquinodimethane and its derivatives; and
(E) Fluorocyclotriphosphazene and its derivatives.

Examples of the compound (A) include C3 to C6 fluoroalkanes represented by the following formula (1) and their derivatives:

CₘHₙF₂ₘ₊₂₋ₙ ... (1)

wherein m is a number of 3 to 6, and n is a number satisfying 0 ≤ n ≤ 2m + 1.

It is particularly preferred to use 1,1,2,2,3,3,4-heptafluorocyclopentane as the sublimable substance. This compound has a vapor pressure of about 8266 Pa at 20°C, a melting point (solidifying point) of 20.5°C, and a boiling point of 82.5°C. Where the sublimable substance is mixed in a melted state with the solvent, the solvent is preferably compatible with the sublimable substance in the melted state. Further, where the sublimable substance is dissolved as the solute in the solvent, the solvent is preferably a solvent in which the sublimable substance is soluble.

Where the sublimable substance is mixed in the melted state with the solvent, the solvent is preferably compatible with the sublimable substance in the melted state. Further, where the sublimable substance is dissolved as the solute in the solvent, the solvent is preferably a solvent in which the sublimable substance is soluble.

The solvent is, for example, at least one selected from the group consisting of DIW, purified water, aliphatic hydrocarbons, aromatic hydrocarbons, esters, alcohols and ethers. Specifically, the solvent is, for example, at least one selected from the group consisting of DIW, purified water, methanol, ethanol, IPA, butanol, ethylene glycol, propylene glycol, NMP (N-methyl-2-pyrrolidone), DMF (N,N-dimethylformamide), DMA (dimethylacetamide), DMSO (dimethyl sulfoxide), hexane, toluene, PGMEA (propylene glycol monomethyl ether acetate), PGME (propylene glycol monomethyl ether), PGPE (propylene glycol monopropyl ether), PGEE (propylene glycol monoethyl ether), GBL (γ-butyrolactone), acetylacetone, 3-pentanone, 2-heptanone, ethyl lactate, cyclohexanone, dibutyl ether, HFE (hydrofluoroether), ethyl nonafluoroisobutyl ether, ethyl nonafluorobutyl ether and m-xylene hexafluoride.

The treatment liquid supplying unit 132 includes a pipe 132a, a valve 132b and a nozzle 132n. The nozzle 132n spouts the treatment liquid toward the upper surface Wa of the substrate W. The nozzle 132n is connected to the pipe 132a. The treatment liquid is supplied from a supply source to the pipe 132a. The valve 132b opens and closes a flow channel inside the pipe 132a. The nozzle 132n is preferably configured to be movable with respect to the substrate W.

The removing liquid supplying unit 134 supplies the removing liquid to the upper surface Wa of the substrate W. The filling layer composed of the solute of the treatment liquid can be removed with the use of the removing liquid. The filling layer can be selectively removed from the substrate W by controlling the period of the supply of the removing liquid.

Usable as the removing liquid is a solvent in which any of the resins is soluble. Usable examples of the removing liquid include thinner, organic solvents such as toluene, acetic acid esters, alcohols and glycols, and acidic liquids such as acetic acid, formic acid and hydroxyacetic acid. It is particularly preferred to use a solvent compatible with the aqueous liquid. For example, isopropyl alcohol (IPA) is preferably used as the removing liquid.

The removing liquid supplying unit 134 includes a pipe 134a, a valve 134b and a nozzle 134n. The nozzle 134n spouts the removing liquid toward the upper surface Wa of the substrate W. The nozzle 134n is connected to the pipe 134a. The removing liquid is supplied from a supply source to the pipe 134a. The valve 134b opens and closes a flow channel inside the pipe 134a. The nozzle 134n is preferably configured to be movable with respect to the substrate W.

The water repellent supplying unit 136 supplies the liquid water repellent to the upper surface Wa of the substrate W. A water repellent layer is formed on the upper surface Wa of the substrate W by the supply of the water repellent.

The water repellent contains, for example, a compound having a terminal methyl group or a terminal silyl group. Typically, hydroxyl groups (OH-groups) are present on the surfaces of the recesses, and hydroxyl groups on the surface of the substrate W are replaced with methyl groups or silyl groups by the water repellent. It is preferred that the water repellent does not alter the properties of the filling layer.

For example, the water repellent is a water repellent that is capable of hydrophobizing silicon (Si) itself and a silicon-containing compound. Typically, the water repellent is a silane coupling agent. In one example, the silane coupling agent contains at least one of HMDS (hexamethyldisilazane), TMS (tetramethylsilane), fluorinated alkylchlorosilanes, alkyldisilazanes and non-chlorinated water repellents. The non-chlorinated water repellents contain, for example, at least one of dimethylsilyldimethylamine, dimethylsilyldiethylamine, hexamethyldisilazane, tetramethyldisilazane, bis(dimethylamino)dimethylsilane, N,N-dimethylaminotrimethylsilane, N-(trimethylsilyl)dimethylamine and organosilane compounds.

The water repellent supplying unit 136 includes a pipe 136a, a valve 136b and a nozzle 136n. The nozzle 136n spouts the water repellent toward the upper surface Wa of the substrate W. The nozzle 136n is connected to the pipe 136a. The water repellent is supplied from a supply source to the pipe 136a. The valve 136b opens and closes a flow channel inside the pipe 136a. The nozzle 136n is preferably configured to be movable with respect to the substrate W.

The chemical liquid supplying unit 138 supplies the chemical liquid to the upper surface Wa of the substrate W. The upper surface Wa of the substrate W is chemically treated with the chemical liquid to be thereby subjected to a chemical liquid treatment. The chemical liquid treatment makes it possible to perform any of the etching process, the surface treatment, the property imparting process, the film forming process and the at least partial film removing process on the substrate W. Typically, the chemical liquid is an etching liquid to be used for the etching process on the substrate W.

The chemical liquid includes hydrofluoric acid. For example, hydrofluoric acid may be heated to not lower than 40°C and not higher than 70°C, or may be heated to not lower than 50°C and not higher than 60°C. However, hydrofluoric acid is not necessarily required to be heated. The chemical liquid may contain water or phosphoric acid.

The chemical liquid may further includes hydrogen peroxide water. Further, the chemical liquid may include SC1 (a mixture liquid of ammonia and hydrogen peroxide water), SC2 (a mixture liquid of hydrochloric acid and hydrogen peroxide water) or aqua regia (a mixture of concentrated hydrochloric acid and concentrated nitric acid) .

The chemical liquid supplying unit 138 includes a pipe 138a, a valve 138b and a nozzle 138n. The nozzle 138n spouts the chemical liquid toward the upper surface Wa of the substrate **W.** The nozzle 138n is connected to the pipe 138a. The chemical liquid is supplied from a supply source to the pipe 138a. The valve 138b opens and closes a flow channel inside the pipe 138a. The nozzle 138n is preferably configured to be movable with respect to the substrate **W.**

As described above, the nozzles 132n, 134n, 136n and 138n of the treatment liquid supplying unit 132, the removing liquid supplying unit 134, the water repellent supplying unit 136 and the chemical liquid supplying unit 138 may be movable. The nozzles 132n, 134n, 136n and 138n can be moved horizontally and/or vertically by a movement mechanism to be controlled by the controller 102. It is herein noted that the movement mechanism is not shown in the drawings for avoidance of excessive complication of the drawings.

The substrate treatment apparatus 100 further includes a cup 180. The cup 180 recovers liquid scattered from the substrate W. The cup 180 is movable upward and downward. For example, the cup 180 is moved up to the lateral side of the substrate W, and is retained at the lateral side during a period in which the liquid supplying unit 130 supplies the liquid to the substrate **W.** In this case, the cup 180 recovers liquid scattered from the substrate W by the rotation of the substrate W. Further, the cup 180 is moved vertically downward from the lateral side of the substrate W after the liquid supplying unit 130 stops supplying the liquid to the substrate **W.**

As described above, the control device 101 includes the controller 102 and the storage 104. The controller 102 controls the substrate holding unit 120, the treatment liquid supplying unit 132, the removing liquid supplying unit 134, the water repellent supplying unit 136, and/or the cup 180. In one example, the controller 102 controls an electric motor 124 and the valves 132b, 134b, 136b and/or 138b.

The substrate treatment apparatus 100 according to this example embodiment is advantageously used for the production of a semiconductor device comprising semiconductor. In the semiconductor device, electrically conductive layers and insulating layers are typically provided on a base. The substrate treatment apparatus 100 is advantageously used to clean and/or process the electrically conductive layers and/or the insulating layers **(e.g.,** for the etching and/or the alteration of properties) in the production of the semiconductor device.

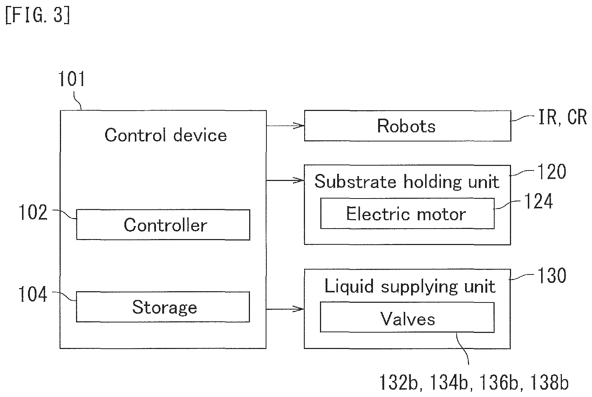

Referring next to FIGS. 1 to 3, the substrate treatment apparatus 100 according to this example embodiment will be described. FIG. 3 is a block diagram of the substrate treatment apparatus 100.

As shown in FIG. 3, the control device 101 controls operations to be performed by the substrate treatment apparatus 100. The control device 101 controls the indexer robot IR, the center robot CR, the substrate holding unit 120 and the liquid supplying unit 130. Specifically, the control device 101 transmits control signals to the indexer robot IR, the center robot CR, the substrate holding unit 120 and the liquid supplying unit 130 to thereby control the indexer robot IR, the center robot CR, the substrate holding unit 120 and the liquid supplying unit 130.

Specifically, the controller 102 controls the indexer robot IR to cause the indexer robot IR to transfer a substrate W.

The controller 102 controls the center robot CR to cause the center robot CR to receive a substrate W. For example, the center robot CR receives an untreated substrate W, and loads the untreated substrate W into any one of the chambers 110. Further, the center robot CR receives a treated substrate W from the chamber 110, and unloads the treated substrate W.

The controller 102 controls the substrate holding unit 120 to start the rotation of the substrate **W,** to change the rotation speed, and to stop the rotation of the substrate W. For example, the controller 102 can change the rotation speed of the substrate holding unit 120 by controlling the substrate holding unit 120. Specifically, the controller 102 can change the rotation speed of the substrate W by changing the rotation speed of the electric motor 124 of the substrate holding unit 120.

The controller 102 individually controls the valves 132b, 134b, 136b, 138b of the liquid supplying unit 130 to switch the valve 132b, 134b, 136b, 138b between an open state and a closed state. Specifically, the controller 102 controls the valve 132b, 134b, 136b, 138b of the liquid supplying unit 130 to open the valve 132b, 134b, 136b, 138b, whereby the treatment liquid, the removing liquid, the water repellent or the chemical liquid respectively flowing in the pipe 132a, 134a, 136a, 138a toward the nozzle 132n, 134n, 136n, 138n can pass through the valve 132b, 134b, 136b, 138b. Further, the controller 102 controls the valve 132b, 134b, 136b, 138b of the liquid supplying unit 130 to close the valve 132b, 134b, 136b, 138b, whereby the supply of the treatment liquid, the removing liquid, the water repellent or the chemical liquid respectively flowing in the pipe 132a, 134a, 136a, 138a toward the nozzle 132n, 134n, 136n, 138n can be stopped.

The substrate treatment apparatus 100 according to this example embodiment is advantageously utilized to form the semiconductor device. For example, the substrate treatment apparatus 100 is advantageously utilized to treat a substrate W to be used for a semiconductor device having a multilayer structure. The semiconductor device is a so-called 3D memory (storage). For example, the substrate W is advantageously used as a NAND flash memory.

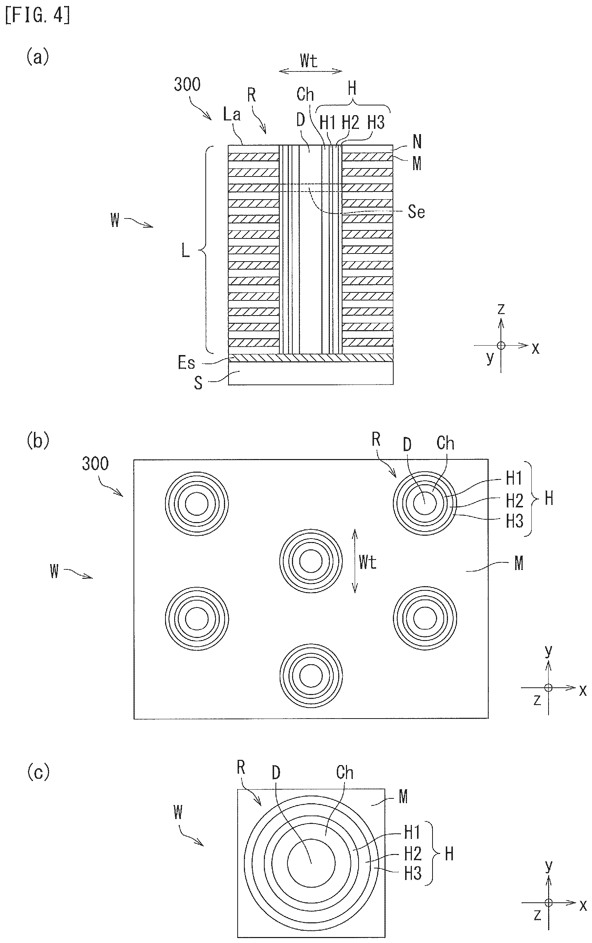

Referring next to FIGS. 4, a substrate W produced in the form of a semiconductor device 300 by using the substrate treatment apparatus 100 according to this example embodiment will be described. FIG. 4(a) is a schematic side view of the semiconductor device 300 produced by treating the substrate W by using the substrate treatment apparatus 100, and FIG. 4(b) is a schematic top plan view of the semiconductor device 300. FIG. 4(c) is a partly enlarged view of FIG. 4(b). In FIGS. 4, a z-direction is defined as a direction orthogonal to the major surface of the base S of the substrate W, and an x-direction and a y-direction are defined as directions orthogonal to the z-direction.

As shown in FIG. 4(a), the substrate W includes a base S and a multilayer structure L. The base S is a thin film extending along an xy-plane. The multilayer structure L is formed on the upper surface of the base S. The base S supports the multilayer structure L. The multilayer structure L extends in the z-direction from the upper surface of the base S.

The substrate W shown in FIG. 4(a) preferably further includes an etching stop layer Es provided between the base S and the multilayer structure L. The etching stop layer Es is formed, for example, of alumina (Al₂O₃). As will be described later in detail, the multilayer structure L is partly removed by the etching to be thereby formed with recesses R. In the example shown in FIGS. 4, the recesses R are memory holes. The etching is stopped by the etching stop layer Es.

The multilayer structure L includes insulating layers N and electrically conductive layers M. The insulating layers N and the electrically conductive layers M are alternatively stacked. For example, the insulating layers N are each composed of a silicon oxide film. Further, the electrically conductive layers M are each composed of a metal. For example, the electrically conductive layers M each comprise tungsten (W).

The insulating layers N each extend parallel to the upper surface of the base S. The electrically conductive layers M are provided between respective adjacent pairs of insulating layers N. The respective adjacent pairs of insulating layers N are supported by the corresponding electrically conductive layers M.

The insulating layers N each have a thickness of, for example, not less than 1 nm and not greater than 50 nm (as measured in the z-direction). The electrically conductive layers M each have a thickness of, for example, not less than 1 nm and not greater than 50 nm (as measured in the z-direction).

The total thickness of a single insulating layer N and a single electrically conductive layer M is not less than 20 nm and not greater than 100 nm. The multilayer structure L includes not less than 10 and not greater than 100 insulating layers N and not less than 10 and not greater than 100 electrically conductive layers M.

The multilayer structure L is provided with recesses R. The recesses R each extend perpendicularly to the major surface of the base S. The recess R extends between the surface La of the multilayer structure L and the etching stop layer Es. A dimension of the recess R as measured perpendicularly to the extending direction of the recess R is herein defined as the width of the recess R. The diameter of the recess R is an example of the width of the recess R.

The diameter of the recess R is on the order of nanometers. For example, the diameter of the recess R is not less than 20 nm and not greater than 300 nm. The diameter of the recess R may be not less than 50 nmand 200 nm.

Ideally, the recess R is formed perpendicularly to the major surface of the base **S.** The diameter of the recess R in the surface (top diameter Wt) is not less than 20 nm and not greater than 300 nm, and may be not less than 50 nm and 200 nm.

For example, the recess R has an aspect ratio of not less than 10. The aspect ratio means a ratio between the height and the width of the recess **R.** Further, it has been reported so far that a memory hole having a height of 1 µm is formed as having an aspect ratio of 40 to 50, and it is considered that the aspect ratio will be further increased in the feature. For example, the upper limit of the aspect ratio of the recess R may be 100, or may be 200.

In the semiconductor device 300 shown in FIG. 4(a), a hollow cylindrical charge retention layer H is provided in the recess R of the substrate **W.** A hollow cylindrical channel layer Ch is provided on the inner side of the charge retention layer **H.** The channel layer Ch is formed, for example, of polysilicon. A cylindrical dielectric layer D is provided on the inner side of the channel layer Ch. The dielectric layer D is composed of a silicon oxide film.

The charge retention layer H may have a three layer structure. For example, the charge retention layer H includes a hollow cylindrical inner layer H1, a hollow cylindrical intermediate layer H2 and a hollow cylindrical outer layer H3. The outer layer H3 contacts the multilayer structure L. The intermediate layer H2 is disposed on the inner side of the outer layer H3. The inner layer H1 is disposed on the inner side of the intermediate layer H2. The inner layer H1 contacts the channel layer Ch. Therefore, the dielectric layer D, the channel layer Ch, the inner layer H1, the intermediate layer H2 and the outer layer H3 are disposed in this order around the center of each of the recesses R of the multilayer structure L.

The inner layer H1 is composed of, for example, a silicon oxide film. The inner layer H1 is also referred to as tunnel layer.

The intermediate layer H2 is composed of, for example, a silicon nitride film. The intermediate layer H2 accumulates charges. The intermediate layer H2 is also referred to as charge accumulation layer.

The outer layer H3 is composed of, for example, a silicon oxide film. The outer layer H3 is also referred to as block layer.

Where a voltage is applied between one of the electrically conductive layers M and the channel layer Ch, charges are accumulated in a corresponding portion of the intermediate layer H2. As shown in FIG. 4(a), memory cells Se are defined as corresponding to the respective electrically conductive layers M. Therefore, the number of the memory cells Se provided in each of the recesses R corresponds to the number of the electrically conductive layers M.

As shown in FIG. 4(b), the plurality of recesses R are provided in the substrate W. The recesses R are regularly arranged in the substrate W. In each of the recesses R, the charge retention layer H, the channel layer Ch and the dielectric layer D are provided. The recesses R are designed so as to have substantially the same diameter and substantially the same height. For example, the recesses R are allowed to differ in top diameter Wt from each other by not greater than 5% or by not greater than 3%.

Typically, the recesses R are formed by dry-etching the multilayer structure L. When the recesses R are formed by the dry etching of the multilayer structure L, the recesses R are each liable to have a smaller diameter in a deeper portion thereof than in a surface-side portion thereof. Particularly, if the height of the multilayer structure L and/or the number of the layers of the multilayer structure L is increased, the recesses R are each more liable to have a smaller diameter in the deeper portion thereof than in the surface-side portion thereof. Further, as the period of the dry etching is reduced for improvement of the throughput, the recesses R are each more liable to have a smaller diameter in the deeper portion thereof than in the surface-side portion thereof.

As shown in FIG. 4(a), the plurality of memory cells Se are provided in each of the recesses R. Therefore, the recesses R preferably each have a constant diameter from the surface-side portion to the deeper portion thereof. However, when the recesses R are formed in the multilayer structure L, the recesses R often each have a nonuniform diameter. If the diameter of the recess R is not uniform when the memory cells are formed in the recess R, the memory cells are likely to have nonuniform electrical characteristics. Therefore, the memory cells often fail to have uniform characteristics.

In general, if the recesses R each have a smaller diameter, a greater number of memory cells can be formed on the base S. Therefore, the recesses R preferably each have a smaller diameter in order to increase the memory capacity. If the recesses R each have a smaller diameter, however, the flow of an etching fluid for the etching of the recesses R is liable to be insufficient. Therefore, the recesses R are each etched nonuniformly depending on a portion thereof. Specifically, the surface-side portions of the recesses R are more liable to be etched, while the deeper portions of the recesses R are less liable to be etched.

According to this example embodiment, as will be described later in detail, the deeper portions of the recesses R (hereinafter referred to as "deeper recess portions Rf") can be selectively etched even if the recesses R each have a smaller diameter. Thus, the nonuniformity of the diameter of each of the recesses R can be suppressed.

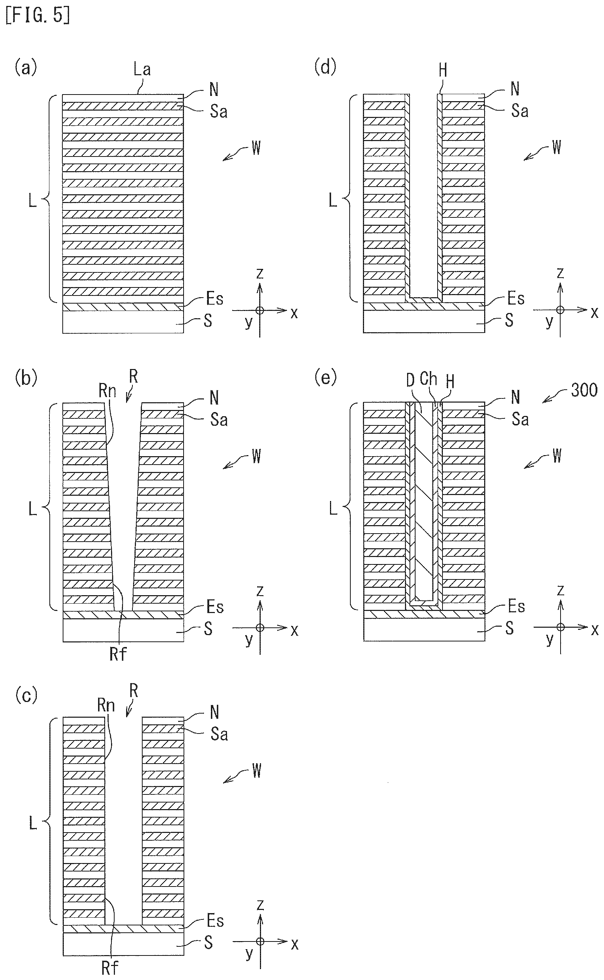

Referring next to FIGS. 5, the semiconductor device forming method according to this example embodiment will be described. Some steps of the semiconductor device forming method according to this example embodiment are performed by using the substrate treatment apparatus 100 described above with reference to FIGS. 1 to 3.

As shown in FIG. 5(a), the substrate W includes a base S and a multilayer structure L. The base S is in the form of a thin film extending along the xy-plane. The multilayer structure L is formed on the upper surface of the base S. The multilayer structure L extends in the z-direction from the upper surface of the base S. For example, the multilayer structure L is composed of silicon oxide films (SiO₂) and silicon nitride films (SiN). The multilayer structure L has a surface La.

The multilayer structure L includes insulating layers N and sacrificial layers Sa. The insulating layers N and the sacrificial layers Sa are alternately stacked. The insulating layers N each extend parallel to the upper surface of the base S. The sacrificial layers Sa are provided between respective adjacent pairs of insulating layers N. The respective adjacent pairs of insulating layers N are supported by the corresponding sacrificial layers Sa. In the process for the production of the semiconductor device 300, the sacrificial layers Sa are replaced with the electrically conductive layers M shown in FIG. 4.

The insulating layers N each have a thickness of, for example, not less than 1 nm and not greater than 50 nm (as measured in the z-direction). The insulating layers N are each composed of a silicon oxide film.

The sacrificial layers Sa each have a thickness of not less than 1 nm and not greater than 50 nm (as measured in the z-direction). The sacrificial layers Sa are each composed of, for example, a silicon nitride film.

As shown in FIG. 5(b), recesses R are formed in the multilayer structure **L.** Typically, the recesses R are each formed by the dry etching. The recess R formed by the dry etching ideally has a constant diameter from the surface-side portion to the deeper portion thereof (as measured along the xy-plane) but, actually, the diameter of the recess R is not constant from the surface-side portion to the deeper portion thereof. Particularly, where the period of the dry etching is reduced for the improvement of the throughput of the substrate W, the recess R is less liable to have a constant diameter from the surface-side portion to the deeper portion thereof. In this case, the recess R has a smaller diameter in the deeper recess portion Rf than in the surface-side portion Rn.

For example, the deeper recess portion Rf is defined as a portion of the recess R closer to the base S. The surface-side portion Rn of the recess R is defined as a portion of the recess R present on a surface side.

As shown in FIG. 5(c), the recess R of the substrate W is altered in shape. For example, the diameter of the deeper recess portion Rf is selectively increased as compared with that observed after the dry etching. For example, the diameter of the deeper recess portion Rf is expanded by less than 10 nm as measured along the xy-plane. Thus, the recess R of the substrate W can be uniformized in diameter from the surface-side portion to the deeper portion thereof.

As shown in FIG. 5(d), a charge retention layer H is formed on the inner side of the recess R of the multilayer structure L.

As shown in FIG. 5(e), a channel layer Ch and a dielectric layer D are formed on the inner side of the charge retention layer H. Thereafter, the sacrificial layers Sa are replaced with the electrically conductive layers M. Thus, the semiconductor device 300 shown in FIGS. 4 can be produced.

In FIG. 5(b), the recess R is illustrated as having a diameter linearly changing from the surface-side portion to the deeper portion thereof for avoidance of excessive complication of the description, but the example embodiment is not limited to this arrangement. The recess R is liable to have the greatest diameter in a middle portion thereof due to a so-called Boeing phenomenon.

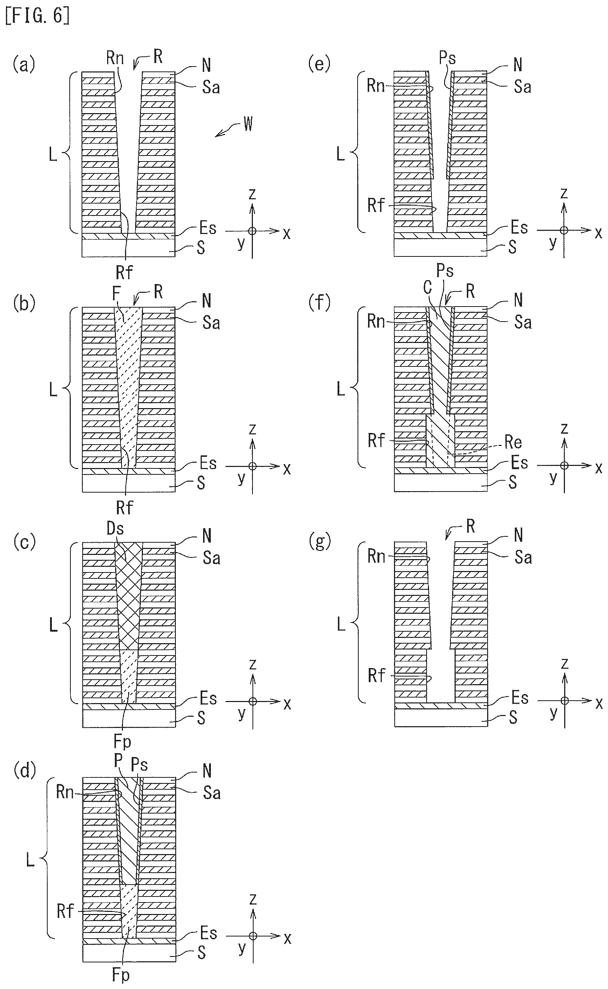

Referring to FIGS. 6, a common semiconductor device forming method will be described. FIGS. 6(a) to 6(g) are schematic diagrams to be used to describe the common semiconductor device forming method.

As shown in FIG. 6(a), the recesses R are formed in the multilayer structure L of the substrate W. As shown in FIG. 6(b), the recesses R are each filled with a filling layer F. As shown in FIG. 6(c), a removing liquid Ds is applied to the substrate W. The removing liquid Ds partly dissolves the filling layer F filled in the recess R. As a result, a partial filling layer Fp is formed from the filling layer F to partly fill the deeper recess portion Rf. As shown in FIG. 6(d), a water repellent P is supplied to the substrate W. Then, the removing liquid Ds is replaced with the water repellent P. Since the surface-side portion Rn of the recess R is not covered with the partial filling layer Fp, the water repellent P reacts with the surface of the multilayer structure L to form a coating film Ps in the surface-side portion Rn of the recess R.

As shown in FIG. 6(e), the partial filling layer Fp and the water repellent P are removed. As shown in FIG. 6(f), the recess R is etched with a chemical liquid C. Since the insulating layers N and the sacrificial layers Sa are exposed in the deeper recess portion Rf, the insulating layers N and the sacrificial layers Sa are etched with the chemical liquid C. Therefore, as shown in FIG. 6(f), a region Re present in the deeper recess portion Rf is removed by the chemical liquid C, whereby the diameter of the recess R is expanded. As shown in FIG. 6(g), the chemical liquid C and the coating film Ps are removed.

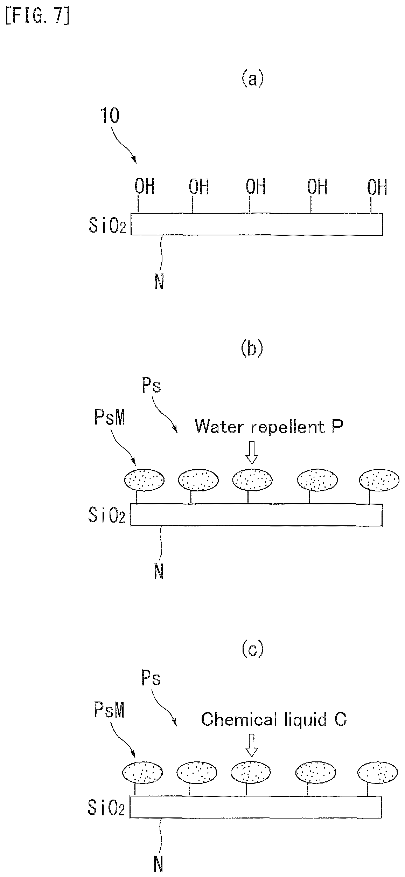

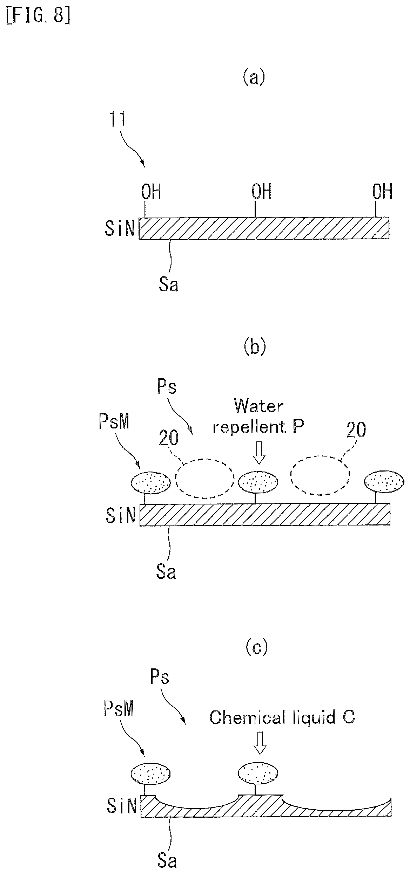

Referring next to FIGS. 7 and 8, the surface states of the multilayer structure L will be described. FIGS. 7(a) to 7(c) are schematic diagrams to be used to describe the surface states of a silicon oxide film provided as the insulating layer N (FIGS. 6) according to a comparative example.

As shown in FIG. 7(a), a plurality of adsorption sites 10 are present on the surface of the insulating layer N. The adsorption sites 10 each contain a hydroxyl group. The adsorption sites are defined as sites that are present on the solid surface of an adsorbent and adsorb molecules of an adsorbate.

As shown in FIG. 7(b), when the water repellent P (FIG. 6(d)) is supplied to the surface of the insulating layer N, the water repellent P reacts with the hydroxyl groups of the adsorption sites 10, whereby the coating film Ps (FIG. 6(d)) is formed. Specifically, the hydroxyl groups of the adsorption sites 10 are replaced with the methyl groups or the silyl groups of the water repellent P, whereby the molecules PsM of a material of the coating film Ps are adsorbed on the surface of the insulating layer N. As a result, the coating film Ps is formed on the insulating layer **N.**

As shown in FIG. 7(c), even if the chemical liquid C is supplied (FIG. 6(f)), the insulating layer N is not etched because the coating film Ps is formed on the insulating layer **N.** In other words, the coating film Ps protects the insulating layer N from the chemical liquid **C.** In other words, the coating film Ps functions as a protection film.

FIGS. 8(a) to 8(c) are schematic diagrams to be used to describe the surface states of a silicon nitride film provided as the sacrificial layer Sa (FIGS. 6).

As shown in FIG. 8(a), a plurality of adsorption sites 11 are present on the surface of the sacrificial layer Sa. The adsorption sites 11 each contain a hydroxyl group. However, the number of the adsorption sites 11 per unit area of the surface of the sacrificial layer Sa is smaller than the number of the adsorption sites 11 per unit area of the surface of the insulating layer N shown in FIG. 7(a). This is because the silicon nitride film is provided as the sacrificial layer Sa.

As shown in FIG. 8(b), when the water repellent P (FIG. 6(d)) is supplied to the surface of the sacrificial layer Sa, the water repellent P reacts with the hydroxyl groups of the adsorption sites 10, whereby the coating film Ps (FIG. 6(d)) is formed. Specifically, the hydroxyl groups of the adsorption sites 11 are replaced with the methyl groups or the silyl groups of the water repellent P, whereby the molecules PsM of the material of the coating film Ps are adsorbed on the surface of the sacrificial layer Sa. As a result, the coating film Ps is formed on the sacrificial layer Sa.

However, the number of the adsorption sites 10 on the surface of the sacrificial layer Sa is smaller (FIG. 8(a)). Therefore, the coating film Ps on the sacrificial layer Sa is liable to have a greater number of non-adsorption areas 20 on which the molecules PsM of the coating film Ps are not adsorbed, as compared with the coating film Ps on the insulating layer N (FIG. 7(b)). The greater number of the non-adsorption areas 20 means that the function of the coating film Ps as the protection film is reduced.

As shown in FIG. 8(c), when the chemical liquid C is supplied (FIG. 6(f)), portions of the sacrificial layer Sa corresponding to the non-adsorption areas 20 are liable to be etched with the chemical liquid C because the coating film Ps on the sacrificial layer Sa has a greater number of non-adsorption areas 20. In this case, the function of the coating film Ps as the protection film is reduced on the sacrificial layer Sa.

Here, as shown in FIG. 6(d), the coating film Ps is formed simultaneously on the insulating layers N and the sacrificial layers Sa by supplying the water repellent P to the recess R. As can be understood from FIGS. 7 and 8, therefore, the insulating layers N present in the surface-side portion Rn of the recess R are not etched with the chemical liquid C because the function of the coating film Ps as the protection film is not reduced on the insulating layers N. On the other hand, the sacrificial layers Sa present in the surface-side portion Rn of the recess R are liable to be etched with the chemical liquid C because the function of the coating film Ps as the protection film is reduced on the sacrificial layers Sa. That is, the sacrificial layers Sa present in the portion of the recess R that does not need the expansion of the diameter (in the surface-side portion Rn) are liable to be etched with the chemical liquid C.

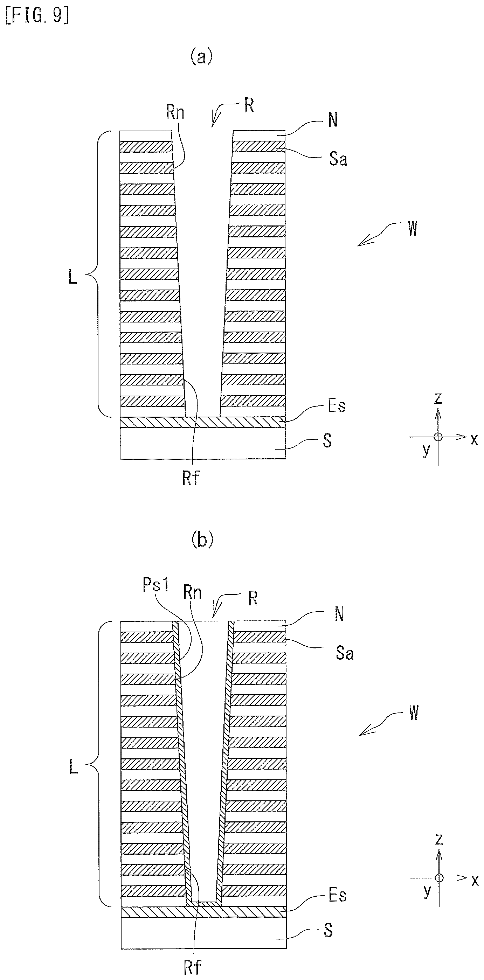

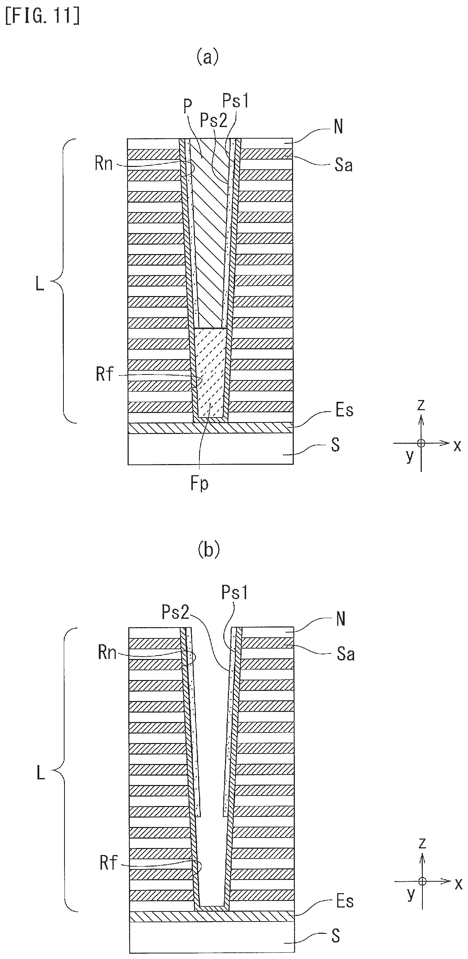

In the semiconductor device forming method according to this example embodiment, therefore, a first coating film Ps1 (FIG. 9(b)) having a greater number of the adsorption sites is formed before a second coating film Ps2 (FIG. 11(a)) corresponding to the coating film Ps is formed.

Referring to FIGS. 9 to 13, the semiconductor device forming method according to this example embodiment will be described. FIGS. 9 to 13 are schematic diagrams to be used to describe the semiconductor device forming method according to this example embodiment. The semiconductor device forming method shown in FIGS. 9 to 13 is advantageously used as a part of the semiconductor device forming method described above with reference to FIGS. 5. For example, the semiconductor device forming method shown in FIGS. 9 to 13 are employed for the alteration of the shape of the recess R shown in FIG. 5(c). The semiconductor device forming method according to this example embodiment is performed by using the substrate treatment apparatus 100 described above with reference to FIGS. 1 to 3.

First, as shown in FIG. 9(a), the recesses R are formed in the multilayer structure L. For example, the recesses R are formed in the multilayer structure L by etching the substrate W. Here, the recesses R are formed in the insulating layers N and the sacrificial layers Sa. The recesses R extend to the etching stop layer Es. The insulating layers N are typically silicon oxide films. The sacrificial layers Sa are typically silicon nitride films.

Next, as shown in FIG. 9(b), the first coating film Ps1 is formed as extending from the deeper recess portion Rf to the surface-side portion Rn. Typically, the first coating film Ps1 is a silicon oxide film. The first coating film Ps1 has a thickness of, for example, not less than 0.1 nm and not greater than 10 nm (as measured in the x-direction).

Typically, the first coating film Ps1 is formed in the recess R by the ALD (Atomic Layer Deposition) method. The ALD method is a film forming method in which the supply and the purge of a vapor-phase raw material (precursor) are repeated to deposit atomic layers one by one to form a film. The ALD method utilizes the self-controllability of atoms. The ALD method makes it possible to precisely uniformly form the first coating film Ps1. It is noted that an ALD apparatus (not shown) is utilized to form the first coating film Ps1 by the ALD method.

The method of forming the first coating film Ps1 is not particularly limited. Alternatively, the formation of the first coating film Ps1 may be achieved, for example, by supplying ozone water, hydrogen peroxide water or the mixture liquid of sulfuric acid and hydrogen peroxide water (sulfuric acid/hydrogen peroxide mixture: SPM) to the recess R.

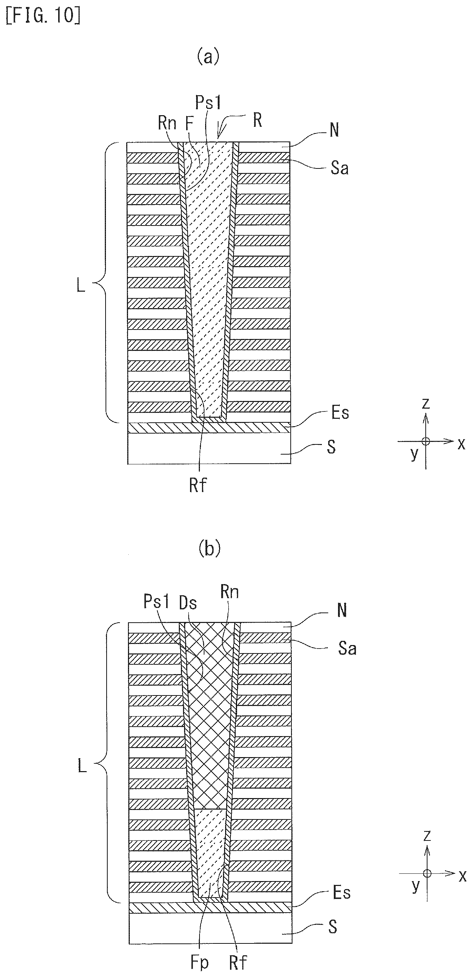

Next, as shown in FIG. 10(a), the recess R is filled with the filling layer F so that the first coating film Ps1 is covered with the filling layer F. For example, the filling layer F is an organic substance (carbon-based material). In one example, the filling layer F is a polymer. The filling layer F may be formed of a resist. For example, the treatment liquid is supplied to the substrate W by the treatment liquid supplying unit 132, and then the solvent is evaporated from the treatment liquid, whereby the filling layer F is formed of the solute of the treatment liquid. Here, the filling layer F fills the recess from the deeper recess portion Rf to the surface-side portion Rn so as to cover the first coating film Ps1.

The treatment liquid is preferably changed into a solid state after being applied to the substrate W. The treatment liquid itself is in a liquid form, but the solvent is evaporated from the treatment liquid after being applied to the substrate W, whereby the solute is solidified to form the filling layer F.

As shown in FIG. 10(b), the removing liquid Ds is supplied to the substrate W. The removing liquid Ds is capable of dissolving the filling layer F. Here, the removing liquid Ds partly dissolves the filling layer F in the recess R. Thus, the deeper recess portion Rf is still filled with the filling layer F, while a part of the filling layer F present in the surface-side portion Rn of the recess R is replaced with the removing liquid Ds. As a result, the partial filling layer Fp which partly fills the deeper recess portion Rf is formed from the filling layer F. It is noted that the removing liquid Ds does not dissolve the first coating film Ps1.

For example, the removing liquid supplying unit 134 supplies the removing liquid Ds to the substrate W. The amount of the removing liquid Ds to be supplied by the removing liquid supplying unit 134 and the period of the supply of the removing liquid Ds are set so that the filling layer F is not entirely dissolved but partly dissolved by the removing liquid Ds. An example of the removing liquid Ds includes isopropyl alcohol (IPA).

Typically, the filling layer F is partly replaced with the removing liquid Ds to a depth not less than one-half the depth of the recess R, and a part of the filling layer F having a length less than one-half the depth of the recess R remains to serve as the partial filling layer Fp. For example, the length of the partial filling layer Fp (as measured in the z-direction) corresponds to not greater than one third the depth of the recess R.

Subsequently, as shown in FIG. 11(a), the water repellent P is supplied. For example, the water repellent supplying unit 136 supplies the water repellent P to the substrate **W.** The partial filling layer Fp is not influenced by the water repellent P, but the removing liquid Ds is replaced with the water repellent P. Thus, the removing liquid Ds present in the surface-side portion Rn of the recess R is replaced with the water repellent P, while the deeper recess portion Rf is still filled with the partial filling layer Fp.

Further, the deeper recess portion Rf is covered with the partial filling layer Fp, but the surface-side portion Rn of the recess R is not covered with the partial filling layer Fp. Therefore, when the water repellent P is supplied, the surface of the first coating film Ps1 reacts with the water repellent P in the surface-side portion Rn of the recess R, whereby the second coating film Ps2 is formed on the first coating film Ps1. The second coating film Ps2 is composed of, for example, a molecular film of an organosilane compound generated by a silane coupling reaction. In one example, the silane coupling agent contains at least one of HMDS (hexamethyldisilazane), TMS (tetramethylsilane), fluorinated alkylchlorosilanes, alkyldisilazanes and non-chlorinated water repellents. The non-chlorinated water repellents contain, for example, at least one of dimethylsilyldimethylamine, dimethylsilyldiethylamine, hexamethyldisilazane, tetramethyldisilazane, bis(dimethylamino)dimethylsilane, N,N-dimethylaminotrimethylsilane, N-(trimethylsilyl)dimethylamine and organosilane compounds. The second coating film Ps2 has a thickness of, for example, not less than 0.5 nm and not greater than 5 nm (as measured in the x-direction). Since the first coating film Ps1 serves as a base for the second coating film Ps2, the first coating film Ps1 may be referred to as a base film.

The deeper recess portion Rf is a portion of the recess R not covered with the second coating film Ps2. In other words, the deeper recess portion Rf is a portion of the recess R closer to the base S than the second coating film Ps2. In other words, the deeper recess portion Rf is a portion of the recess R deeper than the second coating film Ps2.

Next, as shown in FIG. 11(b), the partial filling layer Fp and the water repellent P are removed. In this case, a part of the water repellent P in the surface-side portion of the recess R is removed together with the partial filling layer Fp in the deeper recess portion Rf. At this time, residual particles generated when the recess R is formed (e.g., by the dry etching) are also preferably removed. The first coating film Ps1 is exposed in the deeper recess portion Rf by the removal of the partial filling layer Fp. On the other hand, the surface-side portion Rn of the recess R is still covered with the second coating film Ps2. The second coating film Ps2 covers the first coating film Ps1.

For example, the removing liquid may be applied for the removal of the partial filling layer Fp and the water repellent P. In one example, the removing liquid contains IPA. For example, the removing liquid supplying unit 134 supplies the removing liquid Ds to the substrate W. The amount of the removing liquid Ds to be supplied by the removing liquid supplying unit 134 and the period of the supply of the removing liquid Ds are set so that the partial filling layer Fp can be completely dissolved.

Alternatively, the substrate W may be heated for the removal of the partial filling layer Fp and the water repellent P. Where the partial filling layer Fp is formed of the sublimable substance, for example, the partial filling layer Fp may be sublimated by the heating.

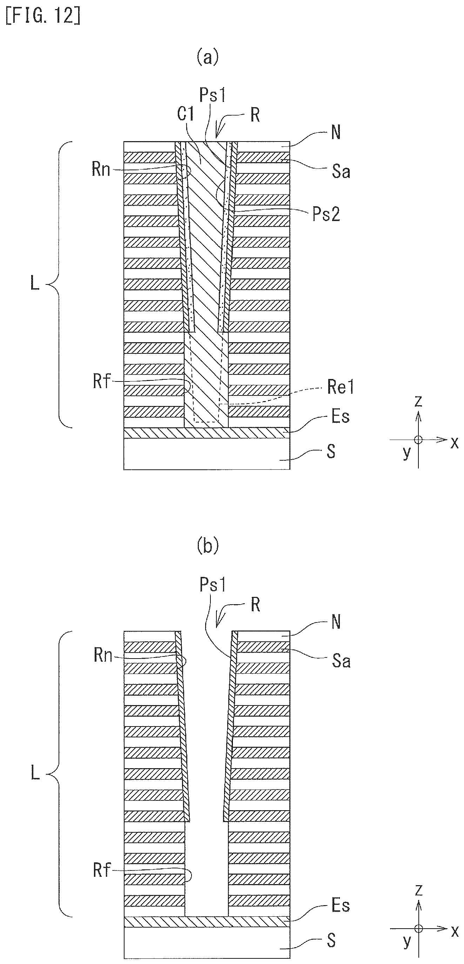

Subsequently, as shown in FIG. 12(a), the recess R is etched with a first chemical liquid C1. Typically, the first chemical liquid C1 contains hydrofluoric acid. For example, the first chemical liquid C1 contains hydrofluoric acid diluted in a ratio of 1:100 to 1:2,000 (dilute hydrofluoric acid). For example, hydrofluoric acid may be heated to not lower than 40°C and not higher than 70°C, or may be heated to not lower than 50°C and not higher than 60°C. Alternatively, the first chemical liquid C1 may contain water or deionized water (DIW). Alternatively, the first chemical liquid C1 may contain phosphoric acid. Alternatively, the first chemical liquid C1 may be fluoride-containing phosphoric acid. The fluoride-containing phosphoric acid is phosphoric acid containing a fluoride. In this case, the fluoride is ammonium fluoride or ammonium bifluoride.

Since the first coating film Ps1 is exposed in the deeper recess portion Rf (FIG. 11(b)), the first coating film Ps1 is etched with the first chemical liquid C1. After the first coating film Ps1 is etched in the deeper recess portion Rf, the insulating layers N and the sacrificial layers Sa are exposed. As a result, the insulating layers N and the sacrificial layers Sa are etched with the first chemical liquid C1 in the deeper recess portion Rf. In this case, the first chemical liquid C1 is a liquid that is capable of etching the insulating layers N and the sacrificial layers Sa at substantially the same rate. Therefore, the deeper recess portion Rf is etched with the first chemical liquid C1 at substantially the same rate. In FIG. 12(a), the deeper recess portion Rf is illustrated as having a generally constant diameter after the etching for avoidance of the complication of the drawing. Further, only the first coating film Ps1 may be etched with the first chemical liquid C1 in the deeper recess portion Rf. In this case, the first coating film Ps1 may be entirely etched, or the first coating film Ps1 may be partly etched.

On the other hand, the surface-side portion Rn of the recess R is coated with the second coating film Ps2 and, therefore, is not etched with the first chemical liquid C1. Therefore, as shown in FIG. 12(a), a region Re1 of the deeper recess portion Rf is removed by the first chemical liquid C1, so that the diameter of the recess R is expanded.

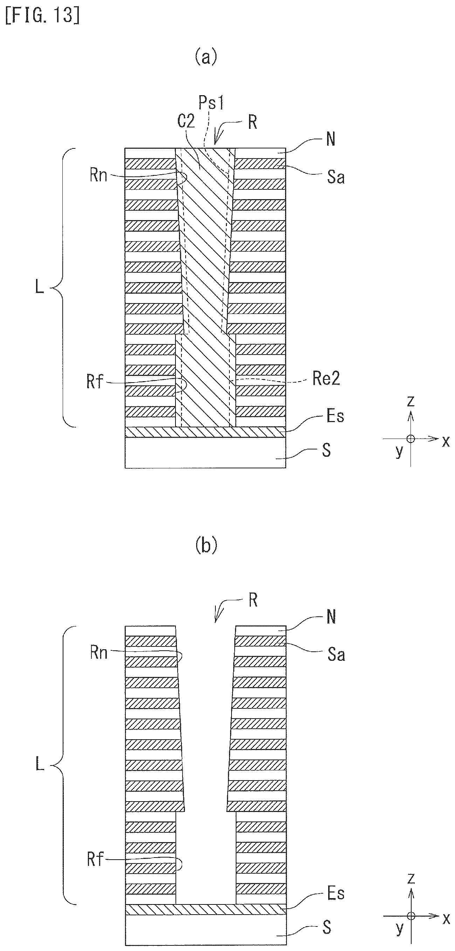

In this case, where the diameter of the deeper recess portion Rf is intended to be finally expanded by U (nm), for example, the diameter of the deeper recess portion Rf is expanded by V (nm). Here, V (nm) is smaller than U (nm). The diameter of the deeper recess portion Rf is first expanded by V (nm) because the insulating layers N and the sacrificial layers Sa are further etched in the deeper recess portion Rf when the first coating film Ps1 is thereafter removed (FIG. 13(a)). The amount of the etching with the first chemical liquid C1 is adjusted, for example, by controlling the period of the etching.

It is noted that the first chemical liquid C1 is a liquid that is capable of etching the first coating film Ps1 but is incapable of etching the second coating film Ps2 or is substantially incapable of etching the second coating film Ps2.

Subsequently, as shown in FIG. 12(b), the first chemical liquid C1 and the second coating film Ps2 are removed. The removal of the first chemical liquid C1 and the second coating film Ps2 may be achieved by ultraviolet irradiation or heating. At this time, a residue present after the dry etching is also preferably removed. The removal of the first chemical liquid C1 and the second coating film Ps2 may be achieved by supplying the SPM to the recess R.

Next, as shown in FIG. 13(a), the first coating film Ps1 is removed by using a second chemical liquid C2. For example, the second chemical liquid C2 is the same as the first chemical liquid C1 used in the step of FIG. 12(a). That is, the second chemical liquid C2 contains hydrofluoric acid. For example, the second chemical liquid C2 contains hydrofluoric acid diluted in a ratio of 1:100 to 1:2,000 (dilute hydrofluoric acid). For example, hydrofluoric acid may be heated to not lower than 40°C and not higher than 70°C, or may be heated to not lower than 50°C and not higher than 60°C. Alternatively, the second chemical liquid C2 may contain water or deionized water (DIW). Alternatively, the second chemical liquid C2 may contain phosphoric acid. Alternatively, the second chemical liquid C2 may contain fluoride-containing phosphoric acid. The fluoride-containing phosphoric acid is phosphoric acid containing a fluoride. In this case, the fluoride is ammonium fluoride or ammonium bifluoride.

The first coating film Ps1 is etched (to be removed) with the second chemical liquid C2 in the surface-side portion Rn of the recess R, and the insulating layers N and the sacrificial layers Sa are etched with the second chemical liquid C2 in the deeper recess portion Rf. Therefore, a region Re2 of the deeper recess portion Rf is removed by the second chemical liquid C2, so that the diameter of the recess R is further expanded. The diameter of the deeper recess portion Rf may be expanded so as to be equal to the diameter of the top portion of the recess R (top diameter).

In this case, the second chemical liquid C2 is a liquid that is capable of etching the first coating film Ps1, the insulating layers N and the sacrificial layers Sa at substantially the same rate. Therefore, the first coating film Ps1 in the surface-side portion Rn and the insulating layers N and the sacrificial layers Sa in the deeper recess portion Rf are etched with the second chemical liquid C2 at substantially the same rate in the recess R. In FIG. 13(a), the deeper recess portion Rf is illustrated as having a generally constant diameter after the etching for avoidance of the complication of the drawing. Further, where the first coating film Ps1 remains in the deeper recess portion Rf, the first coating film Ps1, the insulating layers N and the sacrificial layers Sa are etched with the second chemical liquid C2.

Where the diameter of the deeper recess portion Rf is intended to be finally expanded by U (nm), for example, the diameter of the deeper recess portion Rf is expanded by V (nm) in the step of FIG. 12(a). Here, V (nm) is smaller than U (nm). In the step of FIG. 13(a), therefore, the deeper recess portion Rf is etched with the second chemical liquid C2 so that the diameter thereof is expanded, for example, by (U-V) (nm). The amount of the etching with the second chemical liquid C2 is adjusted by controlling the period of the etching.

Subsequently, as shown in FIG. 13(b), the second chemical liquid C2 is removed from the recess R.

The diameter of the recess R of the multilayer structure L can be adjusted in the aforementioned manner. In FIGS. 13, the deeper recess portion Rf is illustrated as having a diameter that is the same as the top diameter of the recess R and is greater than the diameter of the middle portion of the recess R for easy understanding of a change in the shape of the recess R merely by way of example. The diameter of the deeper recess portion Rf of the recess R may be expanded so as to be equal to the diameter of the middle portion of the recess **R.** Further, the recess R may be modified in shape so that the diameter of the deeper recess portion Rf is equal to the top diameter of the recess R and the diameter of the middle portion of the recess **R.** These modifications may also be made in FIGS. 12.

In FIG. 10(b), the filling layer F is partly replaced with the removing liquid Ds by applying the removing liquid Ds to the filling layer **F.** Where the recess R has a smaller diameter, a relatively long period is required to entirely remove the filling layer F by the removing liquid Ds. Therefore, the filling layer F may be partly removed by interrupting the filling layer removing treatment with the use of the removing liquid Ds during the period required for the entire removal of the filling layer F by the removing liquid Ds. As shown in FIG. 10(b), the partial filling layer Fp can be left so as to cover a proper portion of the recess R by controlling the amount of the removing liquid Ds and the period of the treatment.

In FIG. 10(b), the partial filling layer Fp is formed from the filling layer F by using the removing liquid Ds not by way of limitation in this example embodiment. Where the filling layer F is formed of the sublimable substance, the formation of the partial filling layer Fp from the filling layer F may be achieved by heating. In this case, the partial filling layer Fp partly filling the deeper recess portion Rf may be formed from the filling layer F by controlling the period and the temperature of the heating.

The substrate W is preferably used as a memory including a plurality of memory cells Se. Typically, where the substrate W is used as the memory, the substrate W is formed with a plurality of recesses R designed so as to have the same diameter and the same height. Thus, recesses R to be used for a higher-capacity memory can be subjected to the same treatment to be thereby simultaneously altered in shape.

When the recesses R are formed in the multilayer structure L, the recesses R are each liable to have the greatest diameter in the middle portion thereof due to the Boeing phenomenon. In this case, the second coating film Ps2 preferably covers the middle portion and its periphery. Further, the diameter of the deeper recess portion Rf may be expanded by the etching so as to be equal to the diameter of the middle portion that is the greatest in the recess **R.**

As described above with reference to FIG. 11(a), the second coating film Ps2 is formed by supplying the liquid water repellent P to the recess R filled with the partial filling layer Fp not by way of limitation in this example embodiment. The second coating film Ps2 may be formed from a gas.

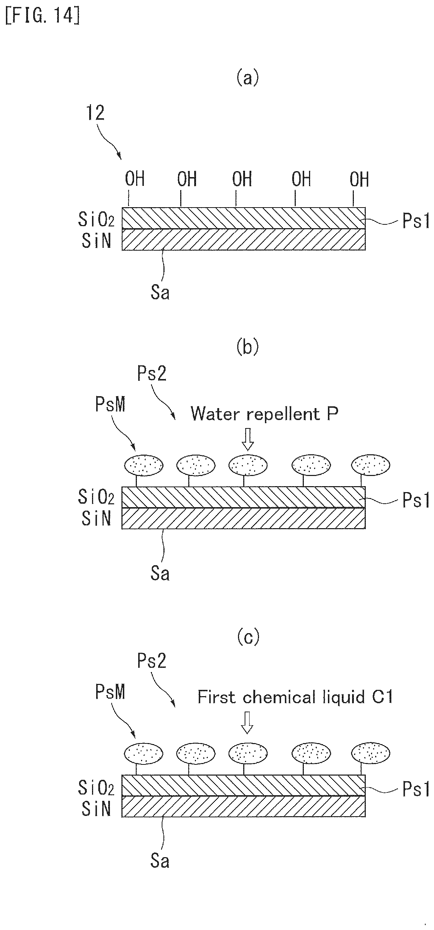

Referring next to FIGS. 14, the surface states of the first coating film Ps1 observed when the second coating film Ps2 is formed will be described. FIGS. 14(a) to 14(c) are schematic diagrams to be used to describe the surface states observed when the second coating film Ps2 is formed on the first coating film Ps1. In FIGS. 14(a) to 14(c), the first coating film Ps1 is illustrated as being provided on the sacrificial layer Sa (silicon nitride film) (FIG. 9(b)). The same first coating film Ps1 as formed on the sacrificial layer Sa is formed on the insulating layer N (silicon oxide film) (FIG. 9(b)).

As shown in FIG. 14(a), a plurality of adsorption sites 12 are present on the surface of the first coating film Ps1. The adsorption sites 12 each contain a hydroxyl group. The number of the adsorption sites 12 per unit area of the surface of the first coating film Ps1 is substantially the same as the number of the adsorption sites 10 per unit area of the surface of the insulating layer N (FIG. 7(a)). This is because the first coating film Ps1 and the insulating layer N are both composed of, for example, silicon oxide films. The number of the adsorption sites 12 per unit area of the surface of the first coating film Ps1 is greater than the number of the adsorption sites 11 per unit area of the sacrificial layer Sa (FIG. 8(a)).

As shown in FIG. 14(b), when the water repellent P is supplied to the surface of the first coating film Ps1, the water repellent P reacts with the hydroxyl groups of the adsorption sites 12 to form the second coating film Ps2 (FIG. 11(a)). Specifically, the hydroxyl groups of the adsorption sites 12 are replaced with the methyl groups or the silyl groups of the water repellent P, whereby the molecules PsM of the material of the second coating film Ps2 are adsorbed on the surface of the first coating film Ps1. As a result, the second coating film Ps2 is formed on the first coating film Ps1. In this case, a greater number of adsorption sites 12 are present on the surface of the first coating film Ps1 (FIG. 14(a)) and, therefore, the second coating film Ps2 has an extremely small number of non-adsorption areas 20 (FIG. 8(b)) as compared with the coating film Ps of the comparative example (FIG. 8(b)). Therefore, the function of the second coating film Ps2 as the protection film is higher than the function of the coating film Ps of the comparative example (FIG. 8(b)) as the protection film whether on the sacrificial layer Sa or on the insulating layer **N.**

As shown in FIG. 14(c), the second coating film Ps2 is formed and, therefore, the sacrificial layer Sa is not etched even if the first chemical liquid C1 is supplied (FIG. 12(a)). In other words, the second coating film Ps2 effectively protects the sacrificial layer Sa from the first chemical liquid C1. In other words, the second coating film Ps2 effectively functions as the protection film. Specifically, a greater number of adsorption sites 12 are present on the surface of the first coating film Ps1 (FIG. 14(a)) and, therefore, the function of the second coating film Ps2 as the protection film is higher than the function of the coating film Ps of the comparative example (FIG. 8(b)) whether on the sacrificial layer Sa or on the insulating layer **N.**

According to this example embodiment, as described above with reference to FIGS. 14, the number of the adsorption sites 12 per unit area of the surface of the first coating film Ps1 for the adsorption of the material of the second coating film Ps2 is greater than an adsorption site number per unit area of the surface of a specific one of different layers (the insulating layer N and the sacrificial layer Sa) of the multilayer structure L. In this case, the specific layer has the smallest adsorption site number per unit area among the different layers of the multilayer structure L (the insulating layer N and the sacrificial layer Sa). In this example embodiment, the specific layer is the sacrificial layer Sa. In this example embodiment, a greater number of adsorption sites 12 are present on the first coating film Ps1, so that the function of the second coating film Ps2 as the protection film is higher than the function of the coating film Ps of the comparative example (FIG. 8(b)) whether on the sacrificial layer Sa or on the insulating layer N. Therefore, the etching with the first chemical liquid C1 can be suppressed on the insulating layers N and the sacrificial layers Sa in a portion of the recess R of the substrate W that does not need the expansion of the diameter (in the surface-side portion Rn).

In this example embodiment, particularly, the adsorption sites 12 present on the surface of the first coating film Ps1 each contain a hydroxyl group. Therefore, the second coating film Ps2 can be easily formed on the first coating film Ps1 by using a compound having a terminal methyl group or a terminal silyl group as the water repellent **P.**

In this example embodiment, the first coating film Ps1 is herein formed so as to cover the insulating layers N and the sacrificial layers Sa in the recess R (FIG. 9(b)). Therefore, the second coating film Ps2 having a higher function as the protection film is formed on the first coating film Ps1 (FIG. 11(a)). As a result, none of the insulating layers N and the sacrificial layers Sa are etched with the first chemical liquid C1 in the surface-side portion Rn of the recess R in the step of FIG. 12(a). That is, the etching with the first chemical liquid C1 can be suppressed on the portion of the recess R that does not need the expansion of the diameter (on the surface-side portion Rn of the recess R). On the other hand, the portion of the recess R that needs the expansion of the diameter (the deeper recess portion Rf) can be etched with the first chemical liquid C1.

In the semiconductor device forming method according to the comparative example shown in FIGS. 6, particularly, the function of the coating film Ps as the protection film is reduced on the sacrificial layers Sa and, therefore, the sacrificial layers Sa present in the portion of the recess R that does not need the expansion of the diameter (in the surface-side portion Rn of the recess R) are liable to be etched (FIG. 8(c)). In the semiconductor device forming method according to this example embodiment, on the other hand, the first coating film Ps1 is first formed on the sacrificial layers Sa and the insulating layers N and then the second coating film Ps2 is formed, whereby the etching with the first chemical liquid C1 can be suppressed not only on the insulating layers N but also on the sacrificial layers Sa.

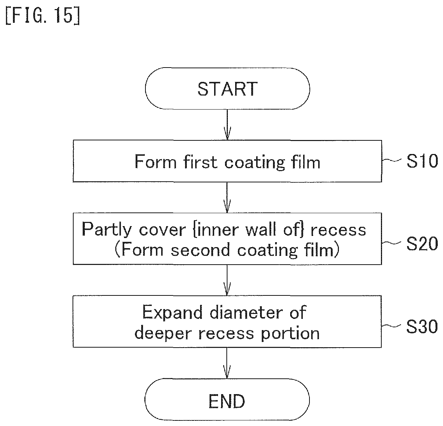

Referring next to FIG. 15, the semiconductor device forming method according to this example embodiment will be described. FIG. 15 is a flow diagram of the semiconductor device forming method. The semiconductor device forming method according to this example embodiment is advantageously performed by using the substrate treatment apparatus 100 described above with reference to FIGS. 1 to 3.

In Step S10, the first coating film Ps1 is first formed in the recess R (FIG. 9(b)). Typically, the first coating film Ps1 is formed in the recess R from the surface-side portion Rn to the deeper recess portions Rf. Specifically, the first coating film Ps1 is formed in the recess provided in the multilayer structure L supported on the base S to cover the recess **R.** Therefore, portions of the insulating layers N and the sacrificial layers Sa exposed in the recess R are covered with the first coating film Ps1.

Next, in Step S20, the recess R of the multilayer structure L is partly covered (FIGS. 11 (a) and 11(b)). Typically, the surface-side portion Rn of the recess R is selectively covered. Specifically, the second coating film Ps2 is formed on the first coating film Ps1 formed in the recess R to selectively cover the surface-side portion Rn of the recess R (present on the surface side). The second coating film Ps2 covers the surface-side portion Rn of the recess R but does not cover the deeper recess portion Rf. Therefore, the first coating film Ps1 is exposed in the deeper recess portion Rf.

Subsequently, in Step S30, the diameter of the deeper recess portion Rf is expanded. The chemical liquid (the first chemical liquid C1 and the second chemical liquid C2) is applied to the recess R, whereby the diameter of the deeper recess portion Rf can be expanded (FIGS. 12(a) and 13(a)). Since the recess R is partly covered with the second coating film Ps2, the diameter of the deeper recess portion Rf of the recess R not covered with the second coating film Ps2 is partly expanded. Thus, the diameter of the deeper recess portion Rf can be expanded, so that the diameter of the recess R can be properly adjusted.

In this example embodiment, as described above with reference to FIG. 15, the second coating film Ps2 is formed on the first coating film Ps1 in the surface-side portion Rn of the recess R (Steps S10 and S20). This increases the function of the second coating film Ps2 as the protection film. As a result, the etching with the chemical liquid (the first chemical liquid C1) can be suppressed on the sacrificial layers Sa and the insulating layers N in the portion of the recess R of the substrate W that does not need the expansion of the diameter (in the surface-side portion Rn) (FIG. 12(a)) in Step S30.

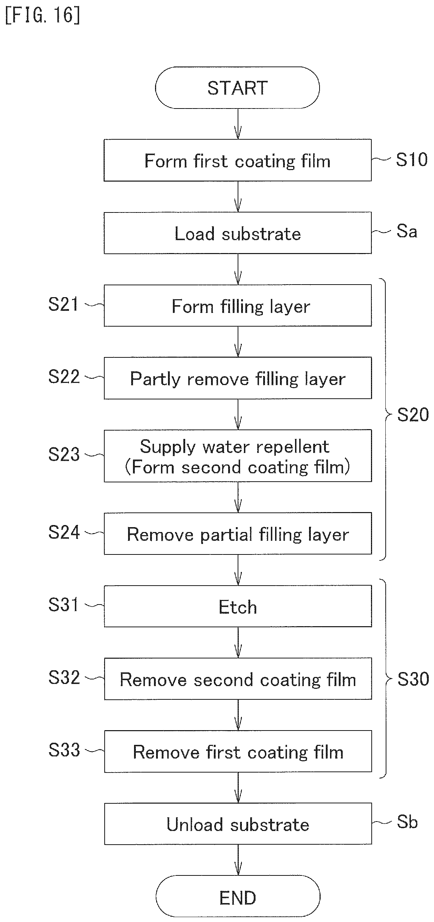

Referring next to FIG. 16, the semiconductor device forming method according to this example embodiment will be described. FIG. 16 is a flow diagram of the semiconductor device forming method. The semiconductor device forming method according to this example embodiment is advantageously performed by using the substrate treatment apparatus 100 described above with reference to FIGS. 1 to 3.

In Step S10, the first coating film Ps1 is first formed in the recess R provided in the multilayer structure L supported on the base S of the substrate W to cover the recess R (FIG. 9(b)). In this case, the first coating film Ps1 is formed, for example, by the ALD method by means of an ALD device provided outside the substrate treatment apparatus 100. The first coating film Ps1 may be formed by using ozone water, hydrogen peroxide water or the SPM. In this case, the liquid supplying unit 130 of the substrate treatment apparatus 100 may include, for example, a fluid supplying unit having substantially the same structure as the treatment liquid supplying unit 132. The fluid supplying unit supplies ozone water, hydrogen peroxide water or the SPM to the upper surface Wa of the substrate W. Where the insulating layers N are silicon oxide films and the sacrificial layers Sa are silicon nitride films, the first coating film Ps1 can be formed of a silicon oxide film by supplying ozone water, hydrogen peroxide water or the SPM to the recess R.

Next, in Step Sa, the substrate W is loaded into the substrate treatment apparatus 100. Here, the substrate W includes the base S and the multilayer structure L, and the multilayer structure L is formed with the recesses R. Further, the first coating film Ps1 is provided in each of the recesses R.

Next, in Step S20, the second coating film Ps2 is formed on the first coating film Ps1 to partly cover the recess R. Here, the partial coverage of the recess R in Step S20 is achieved by the formation of the filling layer F in Step S21, the partial removal of the filling layer F in Step S22 (the formation of the partial filling layer Fp), the supply of the water repellent in Step S23 (the formation of the second coating film Ps2) and the removal of the partial filling layer Fp in Step S24.

First, in Step S21, the recess R is filled with the filling layer F (FIG. 10(a)). Specifically, the filling layer F is formed on the first coating film Ps1 to fill the recess R. For example, the treatment liquid supplying unit 132 supplies the treatment liquid to the substrate W. Thus, the recess R of the substrate W is filled with the filling layer F. Typically, after the supply of the treatment liquid, the substrate holding unit 120 increases the rotation speed of the substrate W, whereby the treatment liquid partly remaining on the surface of the substrate W is scattered outward of the substrate W.

Next, in Step S22, the filling layer F is partly removed (FIG. 10(b)). That is, after the formation of the filling layer F (after Step S21), the filling layer F is partly removed. For example, the removing liquid supplying unit 134 supplies the removing liquid Ds to the substrate W for a predetermined period of time. The removing liquid Ds is applied to the filling layer F in the recess R, whereby the filling layer F is partly dissolved to form the partial filling layer Fp in the recess R. The period of the supply of the removing liquid Ds is set so that the filling layer F can be partly removed from the recess R. At this time, the filling layer F is removed from the surface-side portion Rn of the recess R, while the partial filling layer Fp remains in the deeper recess portion Rf.

Alternatively, the partial filling layer Fp may be formed in the recess R by heating the filling layer F for a predetermined period of time. Where the filling layer F contains the sublimable substance, for example, the filling layer F is heated for the predetermined period of time to be thereby partly sublimated. Thus, the partial filling layer Fp can be formed in the recess R.

Here, Steps S21 and S22 are exemplary steps to be performed to form the partial filling layer Fp on the first coating film Ps1 to partly fill the deeper recess portion Rf of the recess R with the partial filling layer Fp.

Next, in Step S23, the water repellent P is supplied to the substrate W (FIG. 11(a)). That is, after the formation of the partial filling layer Fp (after Step S22), the water repellent P is supplied. The water repellent supplying unit 136 supplies the water repellent P to the substrate W. The water repellent P is applied to the recess R formed with the partial filling layer Fp in the deeper recess portion Rf, whereby the surface-side portion Rn of the recess R not formed with the partial filling layer Fp is filled with the water repellent P to be thereby formed with the water repellent layer. The water repellent layer is formed on the first coating film Ps1. At this time, the properties of the first coating film Ps1 are altered by the water repellent P in the surface-side portion Rn of the recess R, whereby the second coating film Ps2 is formed in the surface-side portion Rn of the recess R. Thus, the second coating film Ps2 is formed as a part of the water repellent layer on the first coating film Ps1 in the surface-side portion Rn of the recess R by the supply of the water repellent P.

Next, in Step S24, the partial filling layer Fp is removed (FIG. 11(b)). That is, after the second coating film Ps2 is formed on the first coating film Ps1 in the surface-side portion of the recess R by the supply of the water repellent P (after Step S23), the partial filling layer Fp and the water repellent P are removed.

Here, a portion of the water repellent layer formed of the water repellent P other than the second coating film Ps2 is removed and, at the same time, the partial filling layer Fp is removed. For example, the removing liquid supplying unit 134 supplies the removing liquid Ds to the substrate W, whereby the partial filling layer Fp is dissolved and the portion of the water repellent layer other than the second coating film Ps2 is replaced with the removing liquid Ds. At this time, the surface-side portion Rn of the recess R is covered with the second coating film Ps2 formed on the first coating film Ps1, while the first coating film Ps1 is exposed in the deeper recess portion Rf.

Alternatively, the removal of the partial filling layer Fp may be achieved by heating the partial filling layer Fp for a predetermined period of time. Where the filling layer F contains the sublimable substance, for example, the filling layer F is partly sublimated by the heating thereof. Thus, the partial filling layer Fp can be removed from the recess R.

Next, in Step S30, the diameter of the deeper recess portion Rf is expanded. For example, the deeper recess portion Rf of the recess R not covered with the second coating film Ps2 is partly etched, whereby the diameter of the recess is expanded.

Here, the expansion of the diameter of the deeper recess portion Rf in Step S30 is achieved by the etching with the first chemical liquid C1 in Step S31, the removal of the second coating film Ps2 in Step S32 and the removal of the first coating film Ps1 in Step S33.

First, in Step S31, the first chemical liquid C1 is supplied to the recess R (FIG. 12(a)). For example, the chemical liquid supplying unit 138 supplies the first chemical liquid C1 to the substrate W. Thus, the deeper recess portion Rf of the recess R not covered with the second coating film Ps2 is partly etched. That is, the deeper recess portion Rf of the recess R not covered with the second coating film Ps2 is etched with the first chemical liquid C1 for the expansion of the diameter of the deeper recess portion Rf.

Next, in Step S32, the second coating film Ps2 is removed from the recess R (FIG. 12(b)). That is, after the etching with the first chemical liquid C1 in Step S31, the second coating film Ps2 is removed. For example, the second coating film Ps2 may be ashed by ultraviolet irradiation or heating to be thereby removed. Step S32 may be performed outside the substrate treatment apparatus 100. Further, the second coating film Ps2 may be removed by the supply of the SPM. In this case, the liquid supplying unit 130 of the substrate treatment apparatus 100 may include a fluid supplying unit, for example, having substantially the same structure as the treatment liquid supplying unit 132. The fluid supplying unit supplies the SPM to the upper surface Wa of the substrate **W.**

Next, in Step S33, the first coating film Ps1 is removed from the recess R (FIG. 13(a)). That is, after the second coating film Ps2 is removed in Step S32, the first coating film Ps1 is removed. Specifically, the second chemical liquid C2 is supplied to the recess R to thereby remove the first coating film Ps1. In this example embodiment, the second chemical liquid C2 is the same as the first chemical liquid C1. For example, the chemical liquid supplying unit 138 supplies the second chemical liquid C2 to the substrate **W.** Thus, the first coating film Ps1 is removed from the recess R by using the second chemical liquid C2. In addition, the deeper recess portion Rf is further etched with the second chemical liquid C2. After the removal of the first coating film Ps1 and the etching are completed, the second chemical liquid C2 is removed from the recess R (FIG. 13(b)).

Next, in Step Sb, the substrate W is unloaded from the substrate treatment apparatus 100. In this manner, the substrate W can be provided, in which variations in recess diameter are suppressed.

According to this example embodiment, as described above with reference to FIG. 16, the first coating film Ps1 is formed in the recess R (Step S10), and the second coating film Ps2 is formed on the first coating film Ps1 (Step S20). Therefore, the etching with the first chemical liquid C1 can be suppressed not only on the insulating layers N but also on the sacrificial layers Sa in the surface-side portion Rn of the recess **R.** That is, the etching with the first chemical liquid C1 can be suppressed on the portion of the recess R of the substrate W that does not need the expansion of the diameter (on the surface-side portion Rn).

In this example embodiment, the material of the first coating film Ps1 and the material of the second coating film Ps2 are different from each other. Therefore, the removal of the second coating film Ps2 in Step S32 and the removal of the first coating film Ps1 in Step S33 are carried out at different times, whereby the first coating film Ps1 and the second coating film Ps2 can be effectively removed by employing different methods according to the properties of the first coating film Ps1 and the second coating film Ps2.

In this example embodiment, the first coating film Ps1 is removed with the use of the second chemical liquid C2, and the deeper recess portion Rf is etched with the second chemical liquid C2 in Step S33. Therefore, the diameter of the deeper recess portion Rf can be expanded to a target value in consideration of the thickness of the first coating film Ps1 to be removed (as measured in the x-direction).

In this example embodiment, the partial filling layer Fp that partly fills the deeper recess portion Rf is formed on the first coating film Ps1, and then the second coating film Ps2 is formed with the use of the water repellent P (Step S20). Thus, the second coating film Ps2 can be formed on the first coating film Ps1 in the surface-side portion Rn of the recess R by a simple process.

In this example embodiment, specifically, after the filling layer F is formed on the first coating film Ps1 (Step S21) and the partial filling layer Fp is formed in the deeper recess portion Rf (Step S22), the second coating film Ps2 is formed with the use of the water repellent P (Step S23). Therefore, the second coating film Ps2 can be easily formed on the first coating film Ps1 in the surface-side portion Rn of the recess R.

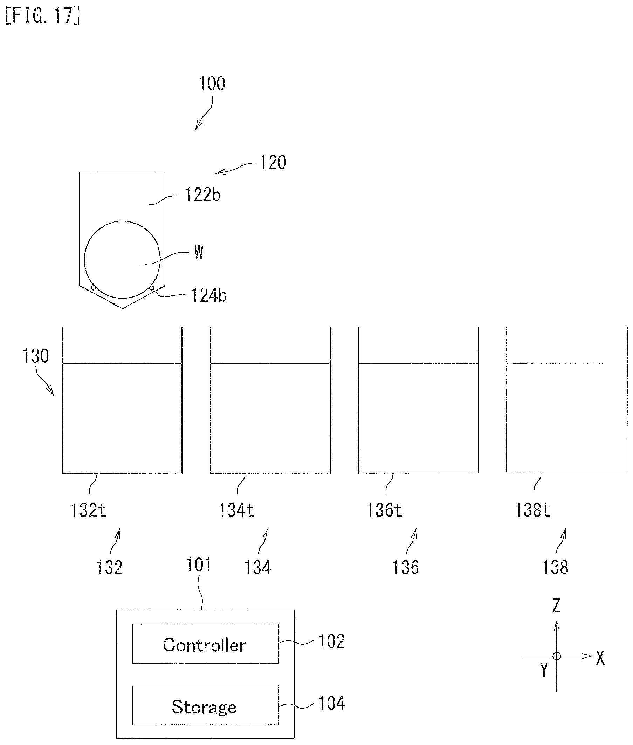

Referring next to FIG. 17, another substrate treatment apparatus 100 according to this example embodiment will be described. FIG. 17 is a schematic diagram of the substrate treatment apparatus 100. The substrate treatment apparatus 100 is capable of treating a plurality of substrates W in a batch.

The substrate treatment apparatus 100 includes a substrate holding unit 120 and a liquid supplying unit 130. The liquid supplying unit 130 includes a treatment liquid supplying unit 132, a removing liquid supplying unit 134, a water repellent supplying unit 136 and a chemical liquid supplying unit 138. The treatment liquid supplying unit 132, the removing liquid supplying unit 134, the water repellent supplying unit 136 and the chemical liquid supplying unit 138 each store liquid.

The treatment liquid supplying unit 132 includes a treatment liquid storage tank 132t. A treatment liquid is stored in the treatment liquid storage tank 132t. A filling layer is formed from the treatment liquid. For example, the treatment liquid contains a solute and a volatile solvent. Alternatively, the treatment liquid contains a sublimable substance.

The removing liquid supplying unit 134 includes a removing liquid storage tank 134t. A removing liquid is stored in the removing liquid storage tank 134t. The filling layer formed from the treatment liquid can be removed with the use of the removing liquid. The filling layer can be selectively removed from the substrate W by controlling the period of the supply of the removing liquid.

Usable as the removing liquid is any solvent in which a given resin is soluble. Usable examples of the removing liquid include thinner, organic solvents such as toluene, acetic acid esters, alcohols and glycols, and acidic liquids such as acetic acid, formic acid and hydroxyacetic acid.

The water repellent supplying unit 136 includes a water repellent storage tank 136t. A liquid water repellent is stored in the water repellent storage tank 136t. A water repellent layer is formed from the water repellent on the substrate W. The water repellent is a water repellent that is capable of hydrophobizing silicon (Si) itself and a silicon-containing compound. The water repellent is, for example, a silane coupling agent. The silane coupling agent contains, for example, at least one of HMDS (hexamethyldisilazane), TMS (tetramethylsilane), fluorinated alkylchlorosilanes, alkyldisilazanes and non-chlorinated water repellents. The non-chlorinated water repellents contain, for example, at least one of dimethylsilyldimethylamine, dimethylsilyldiethylamine, hexamethyldisilazane, tetramethyldisilazane, bis(dimethylamino)dimethylsilane, N,N-dimethylaminotrimethylsilane, N-(trimethylsilyl)dimethylamine and organosilane compounds.

The chemical liquid supplying unit 138 includes a chemical liquid storage tank 138t. A chemical liquid is stored in the chemical liquid storage tank 138t. The substrates W are chemically treated with the chemical liquid to be thereby subjected to the chemical liquid treatment. The chemical liquid treatment makes it possible to perform any of the etching process, the surface treatment, the property imparting process, the film forming process and the at least partial film removing process on the substrates W. Typically, the chemical liquid is an etching liquid to be used for the etching process on the substrates W. In this example embodiment, the chemical liquid is used as the first chemical liquid C1 and the second chemical liquid C2.

The chemical liquid contains hydrofluoric acid. For example, the chemical liquid contains hydrofluoric acid diluted in a ratio of 1:100 to 1:2,000 (dilute hydrofluoric acid). For example, hydrofluoric acid may be heated to not lower than 40°C and not higher than 70°C, or may be heated to not lower than 50°C and not higher than 60°C. However, hydrofluoric acid is not necessarily required to be heated. The chemical liquid may include water or phosphoric acid.

The chemical liquid may further include hydrogen peroxide water. The chemical liquid may include SC1 (a mixture liquid of ammonia and hydrogen peroxide water), SC2 (a mixture liquid of hydrochloric acid and hydrogen peroxide water) or aqua regia (a mixture of concentrated hydrochloric acid and concentrated nitric acid). Alternatively, the chemical liquid may be fluoride-containing phosphoric acid. Fluoride-containing phosphoric acid is phosphoric acid containing a fluoride. In this case, the fluoride is ammonium fluoride or ammonium bifluoride.

The substrate holding unit 120 holds the substrates **W.** A direction normal to the major surfaces of the substrates W held by the substrate holding unit 120 is parallel to a Y-direction. The substrate holding unit 120 is capable of moving the substrates W while holding the substrates **W.** For example, the substrate holding unit 120 is movable vertically upward and downward while holding the substrates **W.** Further, the substrate holding unit 120 may be movable horizontally while holding the substrates **W.**

The substrate holding unit 120 includes a main body plate 122b and a holder rod 124b. The main body plate 122b is a plate extending vertically (in a Z-direction). The holder rod 124b extends from one of opposite major surfaces of the main body plate 122b horizontally (in the Y-direction). Here, the holder rod 124b includes two holder rods 124b extending from the one major surface of the main body plate 122b in the Y-direction. The substrates W are held upright (in a vertical posture) with their lower edges in abutment against the holder rods 124b while being arranged in tandem forward from the paper surface.

The substrate treatment apparatus 100 further includes a control device 101. The control device 101 includes a controller 102 and a storage 104. The controller 102 controls the substrate holding unit 120.

In the substrate treatment apparatus 100 according to this example embodiment, the controller 102 is capable of adjusting the diameters of recesses R provided in the multilayer structure L of each of the substrates W held by the substrate holding unit 120 as in the substrate treatment apparatus of the single substrate treatment type, as described above with reference to FIGS. 9 to 16, by treating the substrates W with different liquids in the same manner as in the substrate treatment method for the single substrate treatment type.

In this example embodiment, the recesses R of the substrates W are each formed with the first coating film Ps1 by the ALD method, and the resulting substrates W are loaded into the substrate treatment apparatus 100. Alternatively, the first coating film Ps1 may be formed with the use of ozone water, hydrogen peroxide water or the SPM. In this case, the liquid supplying unit 130 includes a fluid supplying unit having substantially the same structure as the treatment liquid supplying unit 132 to store, for example, ozone water, hydrogen peroxide water or the SPM.

In this example embodiment, the second coating film Ps2 may be removed by the supply of the SPM. In this case, the liquid supplying unit 130 includes a fluid supplying unit having substantially the same structure as the treatment liquid supplying unit 132 to store the SPM.

In the description with reference to FIGS. 1 to 17, the recesses R of the substrate W are each provided with the memory cells Se not by way of limitation in this example embodiment. Some of the recesses R of the substrate W may be each formed with dummy memory cells that have the same structure as the memory cells Se but do not serve as the memory cells. Alternatively, some of the recesses R of the substrate W may be formed with contact plugs which are electrically connected to the respective memory cells Se.

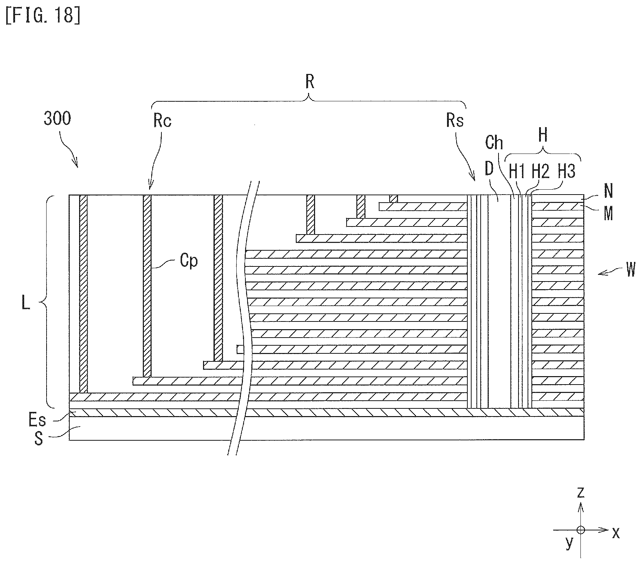

Referring next to FIG. 18, a semiconductor device 300 produced by the semiconductor device forming method according to this example embodiment will be described. FIG. 18 is a schematic diagram of the semiconductor device 300.

The semiconductor device 300 is provided with a plurality of recesses **R.** The recesses R include a memory recess Rs provided with memory cells Se, and contact recesses Rc respectively provided with contact plugs Cp. The contact recesses Rc are respectively connected to electrically conductive layers M.

According to the semiconductor device forming method of this example embodiment, not only the memory recess Rs but also the contact recesses Rc can be each uniformized in diameter from the surface-side portion to the deeper portion thereof. Thus, the strength of the semiconductor device supported by the contact recesses Rc can be uniformized.

While the example embodiment of the present invention has thus been described with reference to the drawings, the present invention is not limited to the example embodiment described above, but various modifications may be made without departing from the scope of the present invention. In addition, various inventive embodiments can be provided by properly combining some of the components disclosed in the above example embodiment. For example, some components may be removed from the components shown in the example embodiment. Further, some components employed in different example embodiments may be combined together as required. In the drawings, the major portions of the components are schematically illustrated for easy understanding thereof, but the illustrated components may be different in thickness, length, number, distance and the like from actual components for convenience of drawing. In the example embodiment, the materials, the shapes, the dimensions and the like of the components are shown by way of example but not by way of limitation. Various modifications may be made substantially without departing from the effects of the present invention.

### INDUSTRIAL APPLICABILITY

The present invention is advantageously applicable to the semiconductor device forming method.

### DESCRIPTION OF REFERENCE CHARACTERS

100: Substrate treatment apparatus
110: Chamber
120: Substrate holding unit
130: Liquid supplying unit
132: Treatment liquid supplying unit
134: Removing liquid supplying unit
136: Water repellent supplying unit
138: Chemical liquid supplying unit
W: substrate

## Claims

1. A semiconductor device forming method comprising the steps of:
forming a first coating film that covers a recess provided in a multilayer structure supported on a base;
forming a second coating film that selectively covers a surface-side portion of the recess formed with the first coating film over the first coating film; and
etching a deeper recess portion of the recess not covered with the second coating film by using a first chemical liquid so as to expand a width of the deeper recess portion.

2. The semiconductor device forming method according to claim 1, further comprising the steps of:
removing the second coating film after the etching step by the first chemical liquid; and
removing the first coating film after the second coating film removing step.

3. The semiconductor device forming method according to claim 2, wherein the first coating film is removed by using a second chemical liquid and the deeper recess portion is etched with the second chemical liquid in the first coating film removing step.

4. The semiconductor device forming method according to claim 1 or 2, wherein the first coating film is formed by using an ALD method, ozone water, hydrogen peroxide water or a mixture liquid of sulfuric acid and hydrogen peroxide water in the first coating film forming step.

5. The semiconductor device forming method according to claim 1 or **2,**
wherein a number of adsorption sites per unit area of a surface of the first coating film for adsorption of a material of the second coating film is greater than an adsorption site number per unit area of a surface of a specific one of different layers of the multilayer structure,
wherein the specific layer has a smallest adsorption site number per unit area among the different layers of the multilayer structure.

6. The semiconductor device forming method according to claim 5, wherein the adsorption sites each contain a hydroxyl group.

7. The semiconductor device forming method according to claim 1 or 2, wherein the second coating film forming step comprises the steps of:
forming a partial filling layer that partly fills the deeper recess portion of the recess over the first coating film;
supplying a water repellent after the formation of the partial filling layer; and
removing the partial filling layer and the water repellent after forming the second coating film on the first coating film in the surface-side portion of the recess by the supply of the water repellent.

8. The semiconductor device forming method according to claim 7, wherein the partial filling layer forming step comprises the steps of:
forming a filling layer that fills the recess over the first coating film; and
partly removing the filling layer after the formation of the filling layer.
